# EUROPEAN PATENT APPLICATION

(11) **EP 4 776 802 A1**
(43) Date of publication of application: **15.07.2026**
(21) Application number: 24861900.9
(22) Date of filing: 30.08.2024
(51) Int. Cl.: H10H 29/01, H10H 20/812

(54) **FULL-COLOR MICRO-LED CHIP, DISPLAY DEVICE, AND MANUFACTURING METHOD**

(30) Priority: 04.09.2023 CN 202311133201
(71) Applicant: Beijing Zitiao Network Technology Co., Ltd., Beijing 100190 (CN)
(72) Inventor: HUANG, Zhen, Beijing 100028 (CN); WANG, Chenggong, Beijing 100028 (CN); LI, Duo, Beijing 100028 (CN); LI, Xiaokai, Beijing 100028 (CN)
(74) Representative: Marks & Clerk LLP
(86) International application number: PCT/CN2024/115798
(87) International publication number: WO 2025/051056

(57) **Abstract**

The present disclosure provides a full-color Micro-LED chip, a display device, and a manufacturing method. The full-color Micro-LED chip comprises a functional layer provided on a substrate layer; the functional layer comprises an n-type semiconductor layer and a quantum well layer which are stacked in a second direction; the functional layer comprises at least one unit group; each unit group comprises a first sub-unit, a second sub-unit, and a third sub-unit which are distributed in a first direction; the first direction intersects with the second direction; and the surface of a blue light quantum well layer of the first sub-unit facing away from the n-type semiconductor layer, the surface of a green light quantum well layer of the second sub-unit facing away from the n-type semiconductor layer, and the surface of a red light quantum well layer of the third sub-unit facing away from the n-type semiconductor layer are flush with one another. According to the present disclosure, simultaneous monolithic integration of RGB full-color Micro-LED chips can be achieved, and the advantages of simple manufacturing process and the like are achieved.

## Description

The present application claims priority to Chinese Patent Application No. 202311133201.4 filed on September 4, 2023, the disclosure of which is incorporated herein by reference in its entirety as a part of the present application.

### TECHNICAL FIELD

The present disclosure relates to a full-color Micro-LED chip and a display apparatus, and preparation methods thereof.

### BACKGROUND

At present, the main full-color schemes for micro light emitting diodes (Micro-LEDs) are: an InGaN-based blue light (B), green light (G) and red light (R) scheme, an InGaN-based blue light, green light and AlGaInP-based red light scheme, and an InGaN-based blue light Micro-LED and red quantum dot and green quantum dot color conversion scheme to achieve full-color display.

Among them, due to factors such as different film formation processes for a blue quantum well layer, a green quantum well layer and a red quantum well layer, to achieve RGB full color by using InGaN materials, it is necessary to independently grow blue, green, and red light LEDs on a sapphire substrate or a silicon substrate, and then sequentially perform Micro-LED chip manufacturing processes, and finally perform bonding with a silicon-based pixel driving circuit, or integration into the silicon-based pixel driving circuit may also be performed by means of "mass transfer", so as to achieve RGB full-color display, and the preparation process is complex.

### SUMMARY

The present disclosure provides a full-color Micro-LED chip and a display apparatus, and preparation methods thereof, which are capable of simultaneously forming a blue quantum well layer, a green quantum well layer and a red quantum well layer on the same substrate layer, to achieve simultaneous monolithic integration of RGB Micro-LED chips, so as to obtain a full-color Micro-LED chip, and which have advantages such as a simple preparation process.

An embodiment of the present disclosure provides a full-color Micro-LED chip, which includes:
a substrate layer; and
a functional layer, disposed on the substrate layer, where the functional layer includes an n-type semiconductor layer and a quantum well layer that are arranged in a second direction; the functional layer includes at least one unit group, each unit group includes a first sub-unit, a second sub-unit, and a third sub-unit that are distributed in a first direction, and the first direction intersects with the second direction; the quantum well layer of the first sub-unit includes a blue quantum well layer; the quantum well layer of the second sub-unit includes a blue quantum well layer and a green quantum well layer that are sequentially arranged on the n-type semiconductor layer in the second direction; the quantum well layer of the third sub-unit includes a blue quantum well layer, a green quantum well layer, and a red quantum well layer that are sequentially arranged on the n-type semiconductor layer in the second direction; and a surface of the blue quantum well layer of the first sub-unit away from the n-type semiconductor layer, a surface of the green quantum well layer of the second sub-unit away from the n-type semiconductor layer, and a surface of the red quantum well layer of the third sub-unit away from the n-type semiconductor layer are flush.

An embodiment of the present disclosure provides a full-color Micro-LED display apparatus, which includes an epitaxial structure formed by the above full-color Micro-LED chip, where the epitaxial structure includes the functional layer; the epitaxial structure includes chip groups in one-to-one correspondence with the unit groups, each of the chip groups includes a first chip structure corresponding to the first sub-unit, a second chip structure corresponding to the second sub-unit, and a third chip structure corresponding to the third sub-unit, and every two of the first chip structure, the second chip structure, and the third chip structure are spaced apart by an isolation layer.

An embodiment of the present disclosure provides a preparation method of the above full-color Micro-LED chip, which includes the following steps:
providing a substrate for forming the substrate layer, where the substrate includes a layer to be patterned, the layer to be patterned has a first side surface and a second side surface that are opposite, and a direction from the first side surface to the second side surface is parallel to the second direction;
performing patterning processing on the first side surface of the layer to be patterned to form at least one mesa group, each mesa group includes a first mesa, a second mesa, and a third mesa that are distributed in the first direction, and taking the second side surface of the layer to be patterned as a reference, a height of the first mesa is greater than a height of the second mesa, and the height of the second mesa is greater than a height of the third mesa; where the layer to be patterned is formed into a patterned layer after the patterning processing;
sequentially epitaxially growing an n-type semiconductor layer and a quantum well layer on the first side surface of the patterned layer, where the quantum well layer includes a blue quantum well layer, a green quantum well layer, and a red quantum well layer that are sequentially grown on the n-type semiconductor layer, a surface of the blue quantum well layer located on the first mesa away from the n-type semiconductor layer, a surface of the green quantum well layer located on the second mesa away from the n-type semiconductor layer, and a surface of the red quantum well layer located on the third mesa away from the n-type semiconductor layer are flush, to form a flush quantum well surface;
removing, by a first etching process, the green quantum well layer and the red quantum well layer located on the first mesa, and the red quantum well layer located on the second mesa to expose the flush quantum well surface, to form at least one unit group on the substrate layer, each unit group includes the first sub-unit located on the first mesa, the second sub-unit located on the second mesa, and the third sub-unit located on the third mesa; and
after exposing the flush quantum well surface, sequentially growing a fourth u-GaN layer, an electron blocking layer, a hole providing layer, and a p-type ohmic contact layer on the flush quantum well surface to obtain the full-color Micro-LED chip.

An embodiment of the present disclosure further provides a preparation method of a full-color Micro-LED display apparatus, which includes the following steps:
providing the above full-color Micro-LED chip, or preparing a full-color Micro-LED chip according to the above preparation method of a full-color Micro-LED chip; and
bonding the full-color Micro-LED chip to a pixel driving circuit element to obtain the full-color Micro-LED display apparatus.

The present disclosure provides a full-color Micro-LED chip and a display apparatus, and preparation methods thereof, in which at least one unit group is simultaneously formed on the same substrate layer, each unit group includes a first sub-unit, a second sub-unit, and a third sub-unit that are distributed in a first direction, a quantum well layer of the first sub-unit includes a blue quantum well layer, a quantum well layer of the second sub-unit includes a blue quantum well layer and a green quantum well layer that are sequentially arranged on an n-type semiconductor layer in a second direction, a quantum well layer of the third sub-unit includes a blue quantum well layer, a green quantum well layer, and a red quantum well layer that are sequentially arranged on the n-type semiconductor layer in the second direction, and a surface of the blue quantum well layer of the first sub-unit away from the n-type semiconductor layer, a surface of the green quantum well layer of the second sub-unit away from the n-type semiconductor layer, and a surface of the red quantum well layer of the third sub-unit away from the n-type semiconductor layer are flush, that is, a flush quantum well surface is formed, and therefore, the blue quantum well layer, the green quantum well layer, and the red quantum well layer may be simultaneously formed on the same substrate layer, so as to achieve simultaneous monolithic integration of RGB LED chips, that is, to obtain the full-color Micro-LED chip and the display apparatus. At the same time, the full-color Micro-LED chip and the display apparatus of the present disclosure have advantages such as a simple preparation process, which is favorable for practical industrial application.

### BRIEF DESCRIPTION OF DRAWINGS

Fig. 1 is a schematic structural diagram of a substrate after a first groove is formed according to an embodiment of the present disclosure;
Fig. 2 is a schematic structural diagram of the substrate after a second groove is formed according to an embodiment of the present disclosure;
Fig. 3 is a schematic structural diagram of the substrate after a dielectric layer is formed on the substrate according to an embodiment of the present disclosure;
Fig. 4 is a schematic structural diagram of the substrate after a buffer layer is formed on the substrate according to an embodiment of the present disclosure;
Fig. 5 is a schematic structural diagram of a first u-GaN layer formed on the buffer layer according to an embodiment of the present disclosure;
Fig. 6 is a schematic structural diagram of an n⁺⁺-GaN heavily doped layer and an n-AlGaN/n-GaN superlattice layer sequentially formed on the first u-GaN layer according to an embodiment of the present disclosure;
Fig. 7 is a schematic structural diagram of a second u-GaN layer and a u-In_{x‴}Ga_{1-x‴}N/u-In_{y‴}Ga_{1-y‴}N superlattice layer sequentially formed on the n-AlGaN/n-GaN superlattice layer according to an embodiment of the present disclosure;
Fig. 8 is a schematic structural diagram of a quantum well layer formed on the u-In_{x‴}Ga_{1-x‴}N/u-In_{y‴}Ga_{1-y‴}N superlattice layer according to an embodiment of the present disclosure;
Fig. 9 is a schematic structural diagram of a red quantum well layer etched off above a first mesa and a second mesa according to an embodiment of the present disclosure;
Fig. 10 is a schematic structural diagram of a flush quantum well surface exposed according to an embodiment of the present disclosure;
Fig. 11 is a schematic structural diagram of a full-color Micro-LED chip according to an embodiment of the present disclosure;
Fig. 12 is a schematic structural diagram of the full-color Micro-LED chip bonded to a pixel driving circuit element according to an embodiment of the present disclosure;
Fig. 13 is a schematic structural diagram of a substrate layer removed during a preparation process of a full-color Micro-LED display apparatus according to an embodiment of the present disclosure;
Fig. 14 is a schematic structural diagram of an n-type semiconductor layer modified during the preparation process of the full-color Micro-LED display apparatus according to an embodiment of the present disclosure;
Fig. 15 is a schematic structural diagram of a first chip structure, a second chip structure, and a third chip structure formed by a second etching process according to an embodiment of the present disclosure; and
Fig. 16 is a schematic structural diagram of a full-color Micro-LED display apparatus according to an embodiment of the present disclosure.

### DETAILED DESCRIPTION

In order for those skilled in the art to better understand the solutions of the present disclosure, the present disclosure will be further described in detail below. The specific implementations listed below are only descriptions of the principles and features of the present disclosure, and the examples are only for explaining the present disclosure, and are not intended to limit the scope of the present disclosure. Based on the embodiments of the present disclosure, all other implementations obtained by those of ordinary skills in the art without paying creative efforts all belong to the protection scope of the present disclosure.

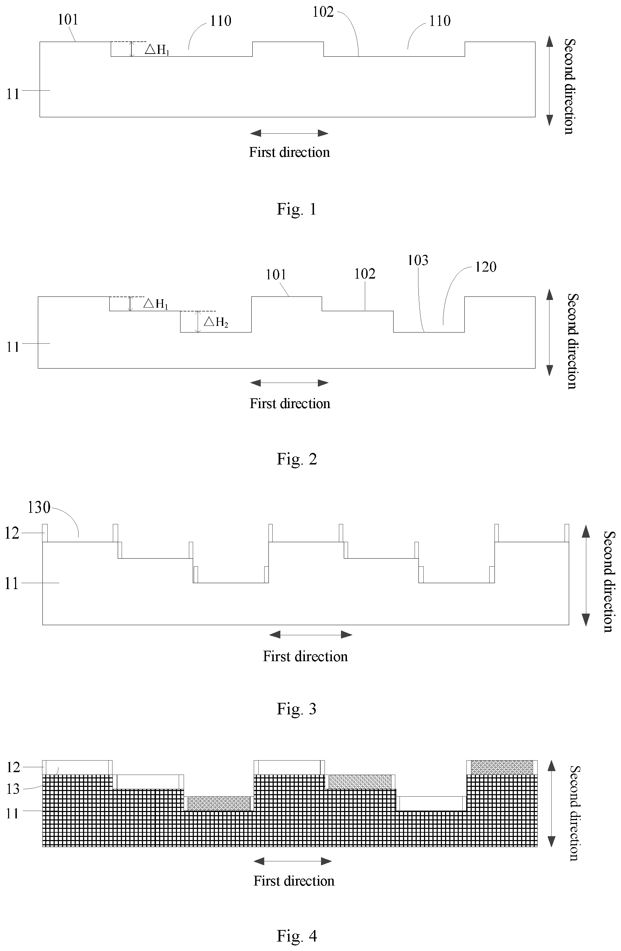

An embodiment of the present disclosure provides a full-color Micro-LED chip, as shown in Fig. 1 to Fig. 11, the full-color Micro-LED chip includes: a substrate layer 1; and a functional layer disposed on the substrate layer 1, where the functional layer includes an n-type semiconductor layer 21 and a quantum well layer 24 that are arranged in a second direction; the functional layer includes at least one unit group 200, each unit group 200 includes a first sub-unit 201, a second sub-unit 202, and a third sub-unit 203 that are distributed in a first direction, and the first direction intersects with the second direction; the quantum well layer 24 of the first sub-unit 201 includes a blue quantum well layer 241; the quantum well layer 24 of the second sub-unit 202 includes a blue quantum well layer 241 and a green quantum well layer 242 that are sequentially arranged on the n-type semiconductor layer 21 in the second direction (these quantum well layers 24 are arranged on a surface of the n-type semiconductor layer 21 away from the substrate layer 1); the quantum well layer 24 of the third sub-unit 203 includes a blue quantum well layer 241, a green quantum well layer 242, and a red quantum well layer 243 that are sequentially arranged on the n-type semiconductor layer 21 in the second direction (these quantum well layers 24 are arranged on a surface of the n-type semiconductor layer 21 away from the substrate layer 1); and a surface of the blue quantum well layer 241 of the first sub-unit 201 away from the n-type semiconductor layer 21, a surface of the green quantum well layer 242 of the second sub-unit 202 away from the n-type semiconductor layer 21, and a surface of the red quantum well layer 243 of the third sub-unit 203 away from the n-type semiconductor layer 21 are flush.

That is, the first sub-unit 201 includes the n-type semiconductor layer 21 and the blue quantum well layer 241 that are sequentially arranged on the substrate layer 1 in the second direction, the second sub-unit 202 includes the n-type semiconductor layer 21, the blue quantum well layer 241, and the green quantum well layer 242 that are sequentially arranged on the substrate layer 1 in the second direction, and the third sub-unit 203 includes the n-type semiconductor layer 21, the blue quantum well layer 241, the green quantum well layer 242, and the red quantum well layer 243 that are sequentially arranged on the substrate layer 1 in the second direction.

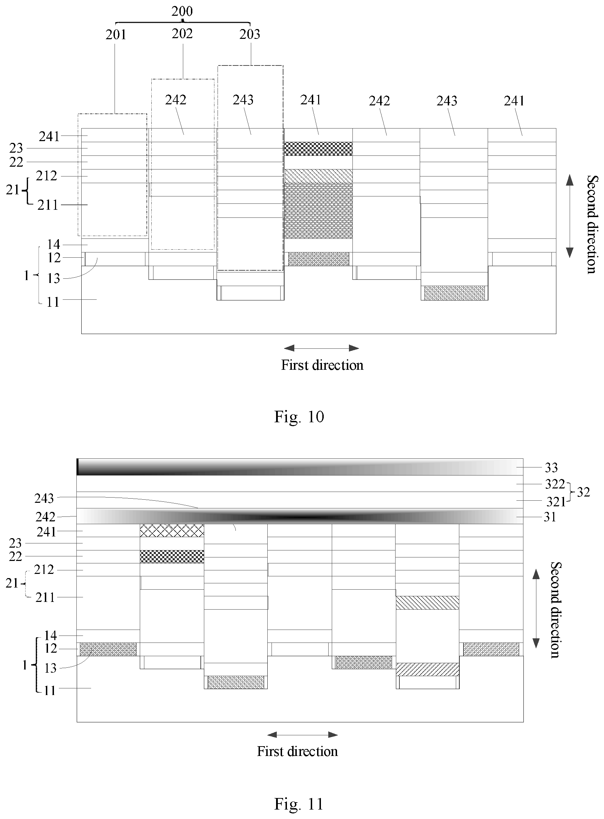

Specifically, in the above full-color Micro-LED chip, the amount of the unit group 200 may be one or more (as shown in Fig. 10 and Fig. 11, the full-color Micro-LED chip includes two unit groups 200), when there are a plurality of unit groups 200, these unit groups 200 may be specifically distributed in the first direction, and every two adjacent unit groups 200 are in direct contact (for example, as shown in Fig. 10 and Fig. 11, a third sub-unit 203 in one unit group 200 may be in direct contact with a first sub-unit 201 in another unit group 200), that is, there is no isolation structure such as a gap or a film layer between the two.

In addition, as shown in Fig. 11, in each unit group 200, the second sub-unit 202 may be between the first sub-unit 201 and the third sub-unit 203, and every two adjacent sub-units of the first sub-unit 201, the second sub-unit 202, and the third sub-unit 203 are in direct contact, that is, there is no isolation structure such as a gap or a film layer between the two adjacent sub-units.

Specifically, referring to Fig. 2, Fig. 10, and Fig. 11, the substrate layer 1 includes a patterned layer located on a surface of the n-type semiconductor layer 21 away from the quantum well layer 24, a surface of the patterned layer facing the n-type semiconductor layer 21 includes mesa groups in one-to-one correspondence with the unit groups 200, each of the mesa groups includes a first mesa 101, a second mesa 102, and a third mesa 103 that are distributed in the first direction, and taking a surface of the patterned layer away from the n-type semiconductor layer 21 as a reference, a height of the first mesa 101 is greater than a height of the second mesa 102, the height of the second mesa 102 is greater than a height of the third mesa 103, the first sub-unit 201 is located on the first mesa 101, the second sub-unit 202 is located on the second mesa 102, and the third sub-unit 203 is located on the third mesa 103.

The above mesas are arranged on the patterned layer to realize a height (thickness) gradient change of the patterned layer (the substrate layer 1), the first sub-unit 201 is formed on the first mesa 101, the second sub-unit 202 is formed on the second mesa 102, and the third sub-unit 203 is formed on the third mesa 103, which is favorable for making that a surface of the blue quantum well layer 241 of the first sub-unit 201 away from the n-type semiconductor layer 21, a surface of the green quantum well layer 242 of the second sub-unit 202 away from the n-type semiconductor layer 21, and a surface of the red quantum well layer 243 of the third sub-unit 203 away from the n-type semiconductor layer 21 are flush, that is, to form a flush quantum well surface.

Under normal circumstances, a height difference ΔH₁ between the first mesa 101 and the second mesa 102 may be basically equal to a thickness of the green quantum well layer 242, and a height difference ΔH₂ between the second mesa 102 and the third mesa 103 may be basically equal to a thickness of the red quantum well layer 243, which is convenient for forming the flush quantum well surface.

Specifically, referring to Fig. 10 and Fig. 11, thicknesses of the n-type semiconductor layers 21 of every two of the first sub-unit 201, the second sub-unit 202, and the third sub-unit 203 are basically the same, and the n-type semiconductor layers 21 of the every two sub-units are arranged in a staggered manner in the second direction. When manufacturing the full-color Micro-LED chip, a layer to be patterned for forming the patterned layer may be first patterned to form the above mesa group on a surface of the layer to be patterned, and then the n-type semiconductor layer 21 is epitaxially grown on the surface of the patterned layer on which the mesa group is formed, thicknesses of the n-type semiconductor layers 21 formed on every two of the first mesa 101, the second mesa 102, and the third mesa 103 are basically the same, and since every two of the first mesa 101, the second mesa 102, and the third mesa 103 have different heights, the n-type semiconductor layers 21 formed on every two of the first mesa 101, the second mesa 102, and the third mesa 103 have different heights (that is, the n-type semiconductor layer 21 formed on every two of the first mesa 101, the second mesa 102, and the third mesa 103 are arranged in a staggered manner in the second direction).

The height difference ΔH₁ between the first mesa 101 and the second mesa 102 may be less than the height difference ΔH₂ between the second mesa 102 and the third mesa 103, but it is not limited thereto.

In some embodiments, the height difference ΔH₁ between the first mesa 101 and the second mesa 102 may be specifically 36 nm to 54 nm, for example, 36 nm, 38 nm, 40 nm, 43 nm, 45 nm, 48 nm, 50 nm, 52 nm, 54 nm, or a range composed of any two of them.

In some embodiments, the height difference ΔH₂ between the second mesa 102 and the third mesa 103 may be 39 nm to 60 nm, for example, 39 nm, 43 nm, 45 nm, 48 nm, 50 nm, 53 nm, 55 nm, 58 nm, 60 nm, or a range composed of any two of them.

Under normal circumstances, a width of the first sub-unit 201 (which is also a width of each film layer in the first sub-unit 201), a width of the second sub-unit 202 (which is also a width of each film layer in the second sub-unit 202), and a width of the third sub-unit 203 (which is also a width of each film layer in the third sub-unit 203) may be respectively 1.9 mm to 4.1 mm, for example, 1.9 mm, 2.3 mm, 2.5 mm, 2.8 mm, 3 mm, 3.3 mm, 3.5 mm, 3.8 mm, 4.1 mm, or a range composed of any two of them.

Widths of every two of the length of the first sub-unit 201 (which is also a length of each film layer in the first sub-unit 201) and the length of the second sub-unit 202 may be equal or unequal; a width of the first mesa 101 is equal to the width of the first sub-unit 201, a width of the second mesa 102 is equal to the width of the second sub-unit 202, and a width of the third mesa 103 is equal to the width of the third sub-unit 203. A width direction of the first sub-unit 201, a width direction of the second sub-unit 202, a width direction of the third sub-unit 203, a width direction of the first mesa 101, a width direction of the second mesa 102, and a width direction of the third mesa 103 are parallel to each other, and they are respectively perpendicular to the first direction and the second direction.

In addition, a length of the first sub-unit 201 (which is also a length of each film layer in the first sub-unit 201), a length of the second sub-unit 202 (which is also a length of each film layer in the second sub-unit 202), and a length of the third sub-unit 203 (which is also a length of each film layer in the third sub-unit 203) may be respectively 2.5 mm to 7 mm, for example, 2.5 mm, 3 mm, 3.5 mm, 4 mm, 4.5 mm, 5 mm, 5.5 mm, 6 mm, 6.5 mm, 7 mm, or a range composed of any two of them.

Lengths of every two of the length of the first sub-unit 201 (which is also the length of each film layer in the first sub-unit 201) and the length of the second sub-unit 202 may be equal or unequal; a length of the first mesa 101 is equal to the length of the first sub-unit 201, a length of the second mesa 102 is equal to the length of the second sub-unit 202, and a length of the third mesa 103 is equal to the length of the third sub-unit 203. A length direction of the first sub-unit 201, a length direction of the second sub-unit 202, a length direction of the third sub-unit 203, a length direction of the first mesa 101, a length direction of the second mesa 102, and a length direction of the third mesa 103 are parallel to each other, and they are respectively parallel to the first direction and perpendicular to the second direction.

Continuing to refer to Fig. 3 to Fig. 5, Fig. 10, and Fig. 11, the substrate layer 1 includes a substrate 11 located on a side of the n-type semiconductor layer 21 away from the quantum well layer 24, a first u-GaN layer (an undoped GaN thin film) 14 located between the substrate 11 and the n-type semiconductor layer 21, a dielectric layer 12 and a buffer layer 13 located between the substrate 11 and the first u-GaN, the dielectric layer 12 is annularly arranged on a peripheral side of the buffer layer 13, that is, the dielectric layer 12 is formed with a third groove 130, the third groove 130 penetrates through the dielectric layer 12 in the second direction (that is, a surface of the substrate 11 is exposed through the third groove 130), the buffer layer 13 is filled in the third groove 130, specifically, the third groove 130 may be fully filled with the buffer layer 13, and a surface of the buffer layer 13 away from the substrate 11 is basically flush with a surface of the dielectric layer 12 away from the substrate 11.

A width of the third groove 130 (that is, a width of an annular pattern formed by the dielectric layer 12 that is not etched) may be 5 µm to 10 µm, for example, 5 µm, 6 µm, 7 µm, 8 µm, 9 µm, 10 µm, or a range composed of any two of them.

The substrate 11 may include a sapphire substrate or a silicon substrate. Under normal circumstances, when the substrate 11 is a silicon substrate, the substrate layer 1 further includes a stress control layer located between the buffer layer 13 and the first u-GaN layer 14, the stress control layer may include an AlGaN layer, in which Al component content has a decreasing trend in a direction from the buffer layer 13 to the first u-GaN layer 14 (parallel to the second direction), and the decreasing trend may be a gradient decrease or a linear gradual decrease (that is, the stress control layer may be a linearly graded AlGaN layer, for example, linearly graded from AlGaN to GaN (that is, the Al component content therein is linearly graded to 0)).

For example, the stress control layer includes an Al_{0.8}Ga_{0.2}N layer, an Al_{0.6}Ga_{0.4}N layer, and an Al_{0.3}Ga_{0.7}N layer that are sequentially arranged on the buffer layer 13 (that is, a surface of the buffer layer 13 away from the substrate 11) in the second direction, so that the Al component content in the stress control layer is gradiently reduced in the direction from the buffer layer 13 to the first u-GaN layer 14.

Specifically, the dielectric layer 12 may include a silicon oxide compound and/or a silicon nitride compound (SiNₓ), and the silicon oxide compound may specifically include silicon dioxide (SiO₂), for example, the dielectric layer 12 may be a SiNₓ film layer or a SiO₂ film layer.

In addition, a thickness of the dielectric layer 12 may be 20 nm to 40 nm, for example, 20 nm, 23 nm, 25 nm, 28 nm, 30 nm, 33 nm, 35 nm, 38 nm, 40 nm, or a range composed of any two of them.

In addition, the buffer layer 13 may include aluminum nitride (AlN), which may specifically be an AlN buffer layer, and the AlN material is used to form the AlN buffer layer, which may improve the film forming quality of the first u-GaN layer 14, reduce non-radiative recombination, and improve the light emitting performance of the device.

In addition, a thickness of the buffer layer 13 may be 20 nm to 40 nm, for example, 20 nm, 23 nm, 25 nm, 28 nm, 30 nm, 33 nm, 35 nm, 38 nm, 40 nm, or a range composed of any two of them.

In addition, a thickness of the first u-GaN layer 14 may be 2 µm to 3 µm, for example, 2 µm, 2.3 µm, 2.5 µm, 2.8 µm, 3 µm, or a range composed of any two of them.

Specifically, the patterned layer may be the substrate 11 (as shown in Fig. 1 to Fig. 11); or, the patterned layer is located between the substrate 11 and the n-type semiconductor layer 21, for example, the patterned layer is the first u-GaN layer 14 formed on the substrate 11.

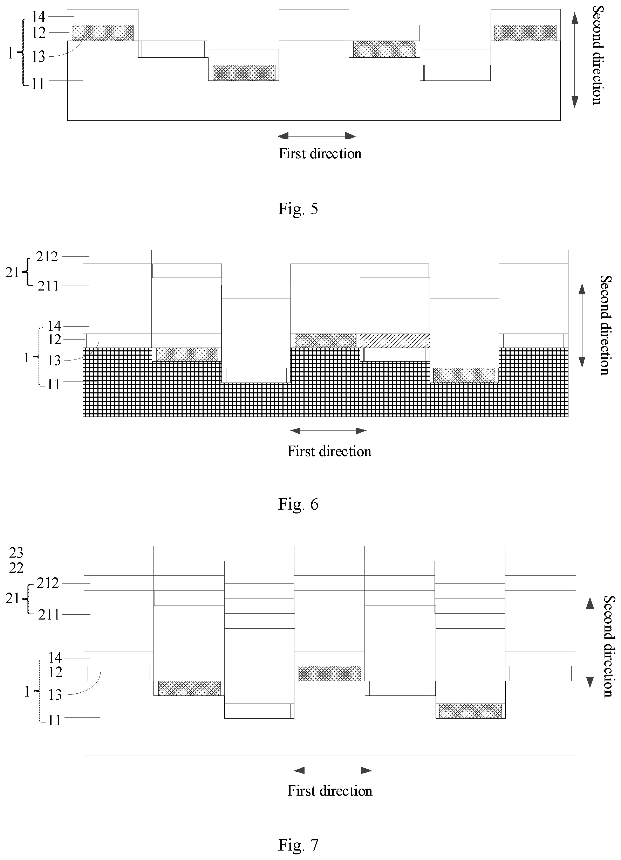

Continuing to refer to Fig. 6 to Fig. 11, the n-type semiconductor layer 21 may include an n⁺⁺-GaN heavily doped layer 211 and an n-AlGaN/n-GaN superlattice layer 212 located between the n⁺⁺-GaN heavily doped layer 211 and the quantum well layer 24, which is favorable for further optimizing the performance of the full-color Micro-LED chip, and by forming the n-AlGaN/n-GaN superlattice layer 212 between the n⁺⁺-GaN heavily doped layer 211 and the quantum well layer 24, the extension of dislocations in the material during the heavy doping process (that is, the formation process of the n⁺⁺-GaN heavily doped layer 211) may be further reduced and the stress may be controlled.

Specifically, the Hall electron concentration of the n⁺⁺-GaN heavily doped layer 211 may be 5×10¹⁸ cm⁻³ to 2×10¹⁹ cm⁻³, for example, 5×10¹⁸ cm⁻³, 8×10¹⁸ cm⁻³, 1×10¹⁹ cm⁻³, 1.3×10¹⁹ cm⁻³, 1.5×10¹⁹ cm⁻³, 1.8×10¹⁹ cm⁻³, 2×10¹⁹ cm⁻³, or a range composed of any two of them.

In addition, a thickness of the n⁺⁺-GaN heavily doped layer 211 may be 1.5 µm to 2.5 µm, for example, 1.5 µm, 1.8 µm, 2 µm, 2.3 µm, 2.5 µm, or a range composed of any two of them.

In addition, the Hall electron concentration of the n-AlGaN/n-GaN superlattice layer 212 may be 1×10¹⁸ cm⁻³ to 1.5×10¹⁸ cm⁻³, for example, 1×10¹⁸ cm⁻³, 1.1×10¹⁸ cm⁻³, 1.2×10¹⁸ cm⁻³, 1.3×10¹⁸ cm⁻³, 1.4×10¹⁸ cm⁻³, 1.5×10¹⁸ cm⁻³, or a range composed of any two of them.

In addition, the amount of the periods of the n-AlGaN/n-GaN superlattice layer 212 is 5 to 10 (that is, an n-AlGaN/n-GaN superlattice layer 212 of 5 to 10 periods may be formed between the n⁺⁺-GaN heavily doped layer 211 and the quantum well layer 24), and the amount of the periods of the n-AlGaN/n-GaN superlattice layer 212 is, for example, 5, 6, 7, 8, 9, or 10.

Specifically, the n-AlGaN/n-GaN superlattice layer 212 includes n-AlGaN layers and n-GaN layers that are alternately arranged in the second direction, that is, the n-AlGaN/n-GaN superlattice layer 212 includes a plurality of repeating units, each of the repeating units includes an n-AlGaN layer and an n-GaN layer that are arranged in the second direction, and the amount of repeating units is the amount of periods of the n-AlGaN/n-GaN superlattice layer 212 (for example, 5 to 10 periods). A thickness of the n-AlGaN layer may be 2 nm to 3 nm, for example, 2 nm, 2.3 nm, 2.5 nm, 2.8 nm, 3 nm, or a range composed of any two of them, the Al component content may be 2% to 8%, for example, 2%, 3%, 4%, 5%, 6%, 7%, 8%, or a range composed of any two of them, and the thickness of the n-GaN layer may be 5 nm to 10 nm, for example, 5 nm, 6 nm, 7 nm, 8 nm, 9 nm, 10 nm, or a range composed of any two of them.

Continuing to refer to Fig. 7 to Fig. 11, the functional layer may further include a second u-GaN layer 22 located between the n-type semiconductor layer 21 and the quantum well layer 24, and a u-In_{x‴}Ga_{1-x‴}N/u-In_{y‴}Ga_{1-y‴}N superlattice layer 23 located between the second u-GaN layer 22 and the quantum well layer 24, 0.01≤x‴≤0.1, y‴=0 or 0.005≤y‴≤0.01.

The amount of periods of the u-In_{x‴}Ga_{1-x‴}N/u-In_{y‴}Ga_{1-y‴}N superlattice layer 23 may be 5 to 10 (that is, a u-In_{x‴}Ga_{1-x‴}N/u-In_{y‴}Ga_{1-y‴}N superlattice layer 23 of 5 to 10 periods may be formed between the second u-GaN layer 22 and the quantum well layer 24), and the amount of periods of the u-In_{x‴}Ga_{1-x‴}N/u-In_{y‴}Ga_{1-y‴}N superlattice layer 23 is, for example, 5, 6, 7, 8, 9, or 10.

Specifically, the u-In_{x‴}Ga_{1-x‴}N/u-In_{y‴}Ga_{1-y‴}N superlattice layer 23 includes u-In_{x‴}Ga_{1-x‴}N layers and u-In_{y‴}Ga_{1-y‴}N layers that are alternately arranged in the second direction, that is, the u-In_{x‴}Ga_{1-x‴}/u-In_{y‴}Ga_{1-y‴}N superlattice layer includes a plurality of repeating units, each of the repeating units includes a u-In_{x‴}Ga_{1-x‴} layer and a u-In_{y‴}Ga_{1-y‴}N layer that are arranged in the second direction, and the amount of the repeating units is the amount of periods of the u-In_{x‴}Ga_{1-x‴}/u-In_{y‴}Ga_{1-y‴}N superlattice layer (for example, 5 to 10 periods).

The thickness of the u-In_{x‴}Ga_{1-x‴}N layer may be 2 nm to 3 nm, for example, 2 nm, 2.3 nm, 2.5 nm, 2.8 nm, 3 nm, or a range composed of any two of them, and the In component content is 1% to 10% (that is, 0.01≤x‴≤0.1), for example, 1%, 2%, 3%, 4%, 5%, 6%, 7%, 8%, 9%, 10%, or a range composed of any two of them.

In addition, the thickness of the u-In_{y‴}Ga_{1-y‴}N layer may be 5 nm to 10 nm, for example, 5 nm, 6 nm, 7 nm, 8 nm, 9 nm, 10 nm, or a range composed of any two of them, and the In component content is 0 (that is, y‴=0, at this time, the u-In_{y‴}Ga_{1-y‴}N layer is a u-GaN layer, and the u-In_{x‴}Ga_{1-x‴}N/u-In_{y‴}Ga_{1-y‴}N superlattice layer 23 is a u-In_{x‴}Ga_{1-x‴}N/u-GaN superlattice layer) or 0.5% to 1% (that is, 0.005≤y‴≤0.01, at this time, the In component content is, for example, 0.5%, 0.6%, 0.7%, 0.8%, 0.9%, 1%, or a range composed of any two of them).

Specifically, referring to Fig. 10 and Fig. 11, in the above full-color Micro-LED chip, each of the first sub-unit 201, the second sub-unit 202, and the third sub-unit 203 includes an n⁺⁺-GaN heavily doped layer 211, an n-AlGaN/n-GaN superlattice layer 212, a second u-GaN layer 22, a u-In_{x‴}Ga_{1-x‴}N/u-In_{y‴}Ga_{1-y‴}N superlattice layer 23, and a quantum well layer 24 that are sequentially arranged in the second direction, and thicknesses of the n⁺⁺-GaN heavily doped layer 211 of every two of the first sub-unit 201, the second sub-unit 202, and the third sub-unit 203 are basically the same, the n⁺⁺-GaN heavily doped layers 211 of the every two sub-units are arranged in a staggered manner in the second direction, thicknesses of the n-AlGaN/n-GaN superlattice layers 212 of the every two sub-units are basically the same, the n-AlGaN/n-GaN superlattice layers 212 of the every two sub-units are arranged in a staggered manner in the second direction, thicknesses of the second u-GaN layers 22 of the every two sub-units are basically the same, the second u-GaN layers 22 of the every two sub-units are arranged in a staggered manner in the second direction, thicknesses of the u-In_{x‴}Ga_{1-x‴}N/u-In_{y‴}Ga_{1-y‴}N superlattice layers 23 of the every two sub-units are basically the same, the u-In_{x‴}Ga_{1-x‴}N/u-In_{y‴}Ga_{1-y‴}N superlattice layers 23 of the every two sub-units are arranged in a staggered manner in the second direction, and a surface of the blue quantum well layer 241 of the first sub-unit 201 away from the n-type semiconductor layer 21, a surface of the green quantum well layer 242 of the second sub-unit 202 away from the n-type semiconductor layer 21, and a surface of the red quantum well layer 243 of the third sub-unit 203 away from the n-type semiconductor layer 21 are flush, so as to form a flush quantum well surface.

Specifically, the blue quantum well layer 241 (a blue quantum well structure) may include 3 to 5 first repeating units, each of the first repeating units includes a first potential well layer and a first potential barrier layer that are arranged in the second direction, the first potential well layer includes a u-InₓGa₁₋ₓN layer, 0.18≤x≤0.2, and the first potential barrier layer includes an n-GaN layer (at this time, the blue quantum well structure is u-InₓGa₁₋ₓN/n-GaN) or a u-In_{y}Ga_{1-y}N layer (at this time, the blue quantum well structure is u-InₓGa₁₋ₓN/u-In_{y}Ga_{1-y}N), 0.01≤y≤0.03.

The In component content in the u-InₓGa₁₋ₓN layer is 18% to 20% (that is, 0.18≤x≤0.2), for example, 18%, 18.5%, 19%, 19.5%, 20%, or a range composed of any two of them.

In addition, the thickness of the first potential well layer may be 2 nm to 3 nm, for example, 2 nm, 2.3 nm, 2.5 nm, 2.8 nm, 3 nm, or a range composed of any two of them.

In addition, when the first potential barrier layer is an n-GaN layer, its Hall electron concentration may be 1×10¹⁷ cm⁻³ to 5×10¹⁷ cm⁻³, for example, 1×10¹⁷ cm⁻³, 2×10¹⁷ cm⁻³, 3×10¹⁷ cm⁻³, 4×10¹⁷ cm⁻³, 5×10¹⁷ cm⁻³, or a range composed of any two of them; when the first potential barrier layer is a u-In_{y}Ga_{1-y}N layer, the In component content therein may be 1% to 3% (that is, 0.01≤y≤0.03), for example, 1%, 1.5%, 2%, 2.5%, 3%, or a range composed of any two of them.

In addition, the thickness of the first potential barrier layer (the n-GaN layer or the u-InyGa1-yN layer) may be 10 nm to 15 nm, for example, 10 nm, 11 nm, 12 nm, 13 nm, 14 nm, 15 nm, or a range composed of any two of them.

Specifically, the green quantum well layer 242 (a green quantum well structure) includes 3 to 5 second repeating units, each of the second repeating units includes a second potential well layer and a second potential barrier layer that are arranged in the second direction, the second potential well layer includes a u-In_{x'}Ga_{1-x'}N layer, 0.25≤x'≤0.28, and the second potential barrier layer includes an n-GaN layer (at this time, the green quantum well structure is u-In_{x'}Ga_{1-x'}N/n-GaN) or a u-In_{y'}Ga_{1-y'}N layer (at this time, the green quantum well structure is u-In_{x'}Ga_{1-x'}N/u-In_{y'}Ga_{1-y'}N), 0.03≤y'≤0.05.

The thickness of the second potential well layer may be 2 nm to 3 nm, for example, 2 nm, 2.3 nm, 2.5 nm, 2.8 nm, 3 nm, or a range composed of any two of them, and the thickness of the second potential barrier layer may be 10 nm to 15 nm, for example, 10 nm, 11 nm, 12 nm, 13 nm, 14 nm, 15 nm, or a range composed of any two of them.

In addition, when the second potential barrier layer is an n-GaN layer, its Hall electron concentration may be 1×10¹⁷cm⁻³ to 5×10¹⁷cm⁻³, for example, 1×10¹⁷cm⁻³, 2×10¹⁷cm⁻³, 3×10¹⁷cm⁻³, 4×10¹⁷cm⁻³, 5×10¹⁷cm⁻³, or a range composed of any two of them.

In addition, when the second potential barrier layer is a u-In_{y}Ga_{1-y}N layer, the In component content therein is 3% to 5% (that is, 0.03≤y'≤0.05), for example, 3%, 3.5%, 4%, 4.5%, 5%, or a range composed of any two of them.

Specifically, the red quantum well layer 243 (a red quantum well structure) includes 3 to 5 third repeating units, each of the third repeating units includes a third potential well layer, a third potential barrier layer, and a u-Al_{z}Ga_{1-z}N layer that are sequentially arranged in the second direction, 0.1≤z≤0.25, the third potential well layer includes a u-In_{x"}Ga_{1-x"}N layer, 0.35≤x"≤0.38, and the third potential barrier layer includes an n-GaN layer (at this time, the red quantum well structure is u-In_{x"}Ga_{1-x"}N/n-GaN/u-Al_{z}Ga_{1-z}N) or a u-In_{y"}Ga_{1-y"}N layer (at this time, the red quantum well structure is u-In_{x"}Ga_{1-x"}N/u-In_{y"}Ga_{1-y"}N/u-Al_{z}Ga_{1-z}N), 0.05≤y"≤0.08. Through the u-Al_{z}Ga_{1-z}N layer, more In may be confined in the quantum well.

A thickness of the third potential well layer may be 2 nm to 3 nm, for example, 2 nm, 2.3 nm, 2.5 nm, 2.8 nm, 3 nm, or a range composed of any two of them, and a thickness of the third potential barrier layer may be 10 nm to 15 nm, for example, 10 nm, 11 nm, 12 nm, 13 nm, 14 nm, 15 nm, or a range composed of any two of them.

In addition, when the third potential barrier layer is an n-GaN layer, its Hall electron concentration may be 1×10¹⁷cm⁻³ to 5×10¹⁷cm⁻³, for example, 1×10¹⁷cm⁻³, 2×10¹⁷cm⁻³, 3×10¹⁷cm⁻³, 4×10¹⁷cm⁻³, 5×10¹⁷cm⁻³, or a range composed of any two of them.

In addition, when the third potential barrier layer is a u-In_{y}Ga_{1-y}N layer, the In component content therein may be 5% to 8% (that is, 0.05≤y''≤0.08), for example, 5%, 5.5%, 6%, 6.5%, 7%, 7.5%, 8%, or a range composed of any two of them.

In addition, a thickness of the u-Al_{z}Ga_{1-z}N layer may be 1 nm to 2 nm, for example, 1 nm, 1.3 nm, 1.5 nm, 1.8 nm, 2 nm, or a range composed of any two of them, and the Al component content therein may be 10% to 25% (that is, 0.1≤z≤0.25), for example, 10%, 13%, 15%, 18%, 20%, 23%, 25%, or a range composed of any two of them.

Continuing to refer to Fig. 11, the functional layer of the full-color Micro-LED chip further includes a fourth u-GaN layer 31, a p-type semiconductor layer 32, and a p-type ohmic contact layer 33 that are sequentially located on a side of the quantum well layer 24 away from the n-type semiconductor layer 21, and the p-type semiconductor layer 32 includes an electron blocking layer 321 and a hole providing layer 322 located between the electron blocking layer 321 and the p-type ohmic contact layer 33, that is, the substrate layer 1, the n-type semiconductor layer 21, the quantum well layer 24, the fourth u-GaN layer 31, the electron blocking layer 321, the hole providing layer 322, and the p-type ohmic contact layer 33 are sequentially arranged in the second direction. Orthographic projections of the fourth u-GaN layer 31, the electron blocking layer 321, the hole providing layer 322, and the p-type ohmic contact layer 33 on the substrate layer 1 respectively cover orthographic projections of the plurality of unit groups 200 on the substrate layer 1.

Specifically, the electron blocking layer 321 includes at least one selected from the group consisting of a p-AlGaN layer, a p-AlGaN/p-GaN superlattice layer, and a p-AlGaN polarization-induced layer (or referred to as a p-AlGaN graded layer or a polarization-induced p-AlGaN doped layer) with Al component content that is linearly graded in the second direction.

The Al component content in the p-AlGaN layer may be 10% to 25% (that is, the p-AlGaN layer may be formed of a p-AlGaN material with the Al component content of 10% to 25%), for example, 10%, 13%, 15%, 18%, 20%, 23%, 25%, or a range composed of any two of them.

In addition, the thickness of the electron blocking layer 321 may be 20 nm to 60 nm, for example, 20 nm, 25 nm, 30 nm, 35 nm, 40 nm, 45 nm, 50 nm, 55 nm, 60 nm, or a range composed of any two of them.

In addition, the hole providing layer 322 may include at least one selected from the group consisting of a p-GaN layer, a p-AlGaN/p-GaN superlattice layer, and a p-AlGaN polarization-induced layer with Al component content that is linearly graded in the second direction.

The thickness of the p-GaN layer may be 100 nm to 160 nm, for example, 100 nm, 110 nm, 120 nm, 130 nm, 140 nm, 150 nm, 160 nm, or a range composed of any two of them.

Relatively speaking, the electron blocking layer 321 and/or the hole providing layer 322 using the p-AlGaN polarization-induced layer may increase a hole concentration and conductivity of the material, increase a quantum well electron-hole recombination rate, reduce power consumption of a full-color Micro-LED display apparatus formed by the full-color Micro-LED chips, and improve luminous efficiency.

Exemplarily, the hole providing layer 322 may include a double-layer p-AlGaN polarization-induced layer (that is, two layers (the double-layer) of the p-AlGaN polarization-induced layers are arranged in a stacked (laminated) manner in the second direction).

Specifically, in the electron blocking layer 321 or the hole providing layer 322, the p-AlGaN/p-GaN superlattice layer includes p-AlGaN layers and p-GaN layers that are alternately arranged in the second direction, that is, the p-AlGaN/p-GaN superlattice layer includes a plurality of repeating units, and each of the repeating units includes a p-AlGaN layer and a p-GaN layer that are arranged in the second direction. The thickness of the p-AlGaN layer may be 2 nm to 3 nm, for example, 2 nm, 2.3 nm, 2.5 nm, 2.8 nm, 3 nm, or a range composed of any two of them, and the content of the Al component may be 20% to 25%, for example, 20%, 21%, 22%, 23%, 24%, 25%, or a range composed of any two of them; the thickness of the p-GaN layer may be 5 nm to 10 nm, for example, 5 nm, 6 nm, 7 nm, 8 nm, 9 nm, 10 nm, or a range composed of any two of them.

Exemplarily, when the hole providing layer 322 includes the p-AlGaN/p-GaN superlattice layer, the amount of the periods of the p-AlGaN/p-GaN superlattice layer may be 10 periods to 13 periods (that is, the amount of its repeating units is 10 to 13).

In addition, the p-type ohmic contact layer 33 may include one or more of a p⁺⁺-GaN heavily doped layer, an ITO (indium tin oxide) film layer, a p-InGaN/p-GaN superlattice layer, and a p-AlGaN polarization-induced layer with an Al component content that is linearly graded in the second direction.

The dopant in the p⁺⁺-GaN heavily doped layer may include Mg, and the Hall hole concentration of the p⁺⁺-GaN heavily doped layer may be 2×10²⁰ cm⁻³ to 4×10²⁰ cm⁻³, for example, 2×10²⁰ cm⁻³, 2.5×10²⁰ cm⁻³, 3×10²⁰ cm⁻³, 3.5×10²⁰ cm⁻³, 4×10²⁰ cm⁻³, or a range composed of any two of them, and the thickness of the p⁺⁺-GaN heavily doped layer may be 10 nm to 40 nm, for example, 10 nm, 15 nm, 20 nm, 25 nm, 30 nm, 35 nm, 40 nm, or a range composed of any two of them.

The p-InGaN/p-GaN superlattice layer includes p-InGaN layers and p-GaN layers that are alternately arranged in the second direction, that is, the p-InGaN/p-GaN superlattice layer includes a plurality of repeating units, each of the repeating units includes a p-InGaN layer and a p-GaN layer that are arranged in the second direction, and the amount of repeating units is the amount of periods of the p-InGaN/p-GaN superlattice layer (for example, 3 to 5 periods, that is, the p-type ohmic contact layer may include a p-InGaN/p-GaN superlattice layer of 3 to 5 periods). The thickness of the p-InGaN layer may be 2 nm to 3 nm, for example, 2 nm, 2.3 nm, 2.5 nm, 2.8 nm, 3 nm, or a range composed of any two of them, and the In component content may be 5% to 10%, for example, 5%, 6%, 7%, 8%, 9%, 10%, or a range composed of any two of them; the thickness of the p-GaN layer may be 5 nm to 10 nm, for example, 5 nm, 6 nm, 7 nm, 8 nm, 9 nm, 10 nm, or a range composed of any two of them.

Specifically, in the p-AlGaN polarization-induced layer as described above, the Al component content is linearly graded from 30% to 0 in the second direction, and specifically may be linearly graded from 30% to 0 in a direction from the n-type semiconductor layer 21 (or the substrate layer 1) to the quantum well layer 24.

The thickness of the p-AlGaN polarization-induced layer may be 60 nm to 80 nm, for example, 60 nm, 63 nm, 65 nm, 68 nm, 70 nm, 73 nm, 75 nm, 78 nm, 80 nm, or a range composed of any two of them.

Unless otherwise specified, the thickness described in the embodiments of the present disclosure is a single-layer thickness, for example, the thickness of the p-AlGaN polarization-induced layer may be 60 to 80 nm, which means that the thickness of one p-AlGaN polarization-induced layer is 60 nm to 80 nm, and taking the hole providing layer 322 as an example, when the hole providing layer 322 includes a double-layer p-AlGaN polarization-induced layer, its thickness is a sum of thicknesses of the two p-AlGaN polarization-induced layers, that is, 120 nm to 160 nm.

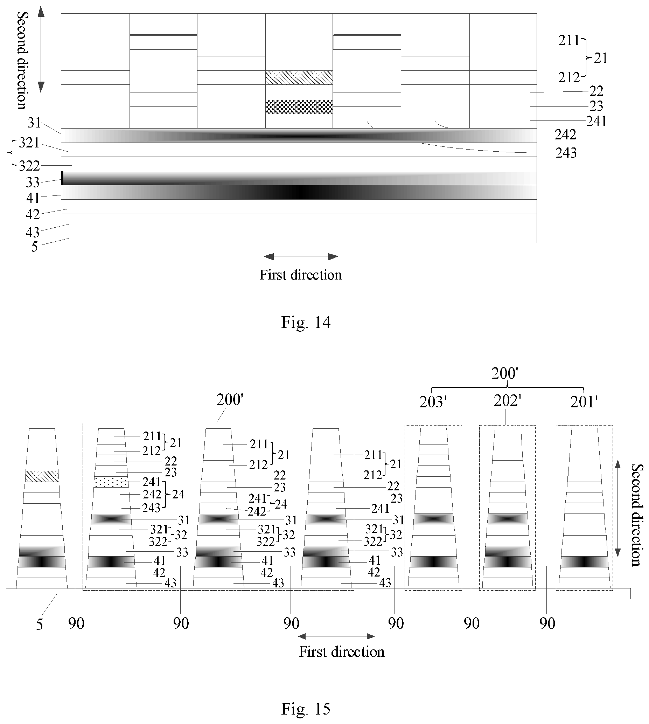

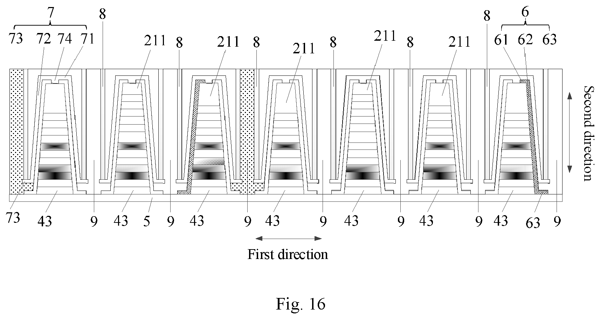

An embodiment of the present disclosure further provides a full-color Micro-LED display apparatus, as shown in Fig. 15 and Fig. 16, the full-color Micro-LED display apparatus includes an epitaxial structure formed by the above-mentioned full-color Micro-LED chip, where the epitaxial structure includes the above functional layer, the epitaxial structure includes chip groups 200' in one-to-one correspondence with the unit groups 200, each of the chip groups 200' includes a first chip structure 201' corresponding to the first sub-unit 201, a second chip structure 202' corresponding to the second sub-unit 202, and a third chip structure 203' corresponding to the third sub-unit 203, and every two of the first chip structure 201', the second chip structure 202', and the third chip structure 203' are spaced apart by an isolation layer 9.

Continuing to refer to Fig. 15 and Fig. 16, the epitaxial structure further includes a fourth u-GaN layer 31, a p-type semiconductor layer 32, and a p-type ohmic contact layer 33 that are sequentially located on a side of the quantum well layer 24 away from the n-type semiconductor layer 21, and the p-type semiconductor layer 32 includes an electron blocking layer 321 and a hole providing layer 322 located between the electron blocking layer 321 and the p-type ohmic contact layer 33, and these layers all originate from the full-color Micro-LED chip.

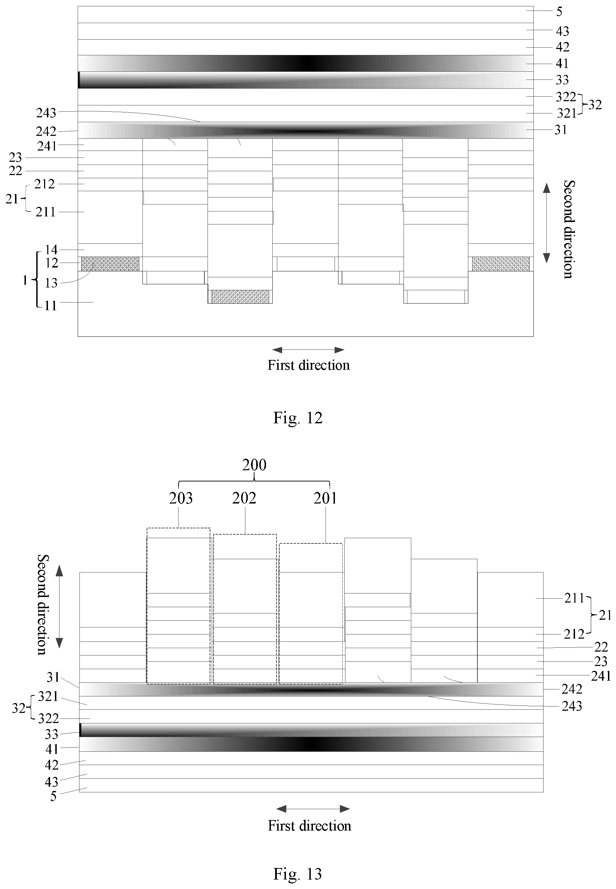

Referring to Fig. 12 to Fig. 16, the full-color Micro-LED display apparatus further includes a first transparent conductive layer 41, a reflective layer 42, a metal bonding layer 43, and a pixel driving circuit element 5 that are sequentially located on a side of the p-type ohmic contact layer 33 away from the p-type semiconductor layer 32.

As shown in Fig. 16, the isolation layer 9 extends from the n-type semiconductor layer 21 to the metal bonding layer 43 and penetrates through the n-type semiconductor layer 21 and the metal bonding layer 43, specifically extends from the n⁺⁺-GaN heavily doped layer 211 to the metal bonding layer 43 and penetrates through the n⁺⁺-GaN heavily doped layer 211 and the metal bonding layer 43, that is, the isolation layer 9 ends at a surface of the pixel driving circuit element 5 facing the epitaxial structure, and orthographic projections of the first chip structure 201', the second chip structure 202', the third chip structure 203', and the isolation layer 9 on the pixel driving circuit element 5 are all covered by the pixel driving circuit element 5.

Specifically, the first chip structure 201' includes the functional layer in the first sub-unit 201, that is, the first chip structure includes the n-type semiconductor layer 21 and the quantum well layer 24 that are arranged in the second direction, and the quantum well layer 24 of the first chip structure 201' includes the blue quantum well layer 241; the second chip structure 202' includes the functional layer in the second sub-unit 202, that is, the second chip structure 202' includes the n-type semiconductor layer 21 and the quantum well layer 24 that are arranged in the second direction, and the quantum well layer 24 of the second chip structure 202' includes the blue quantum well layer 241 and the green quantum well layer 242 located on a side of the blue quantum well layer 241 away from the n-type semiconductor layer 21; the third chip structure 203' includes the functional layer in the third sub-unit 203, that is, the third chip structure 203' includes the n-type semiconductor layer 21 and the quantum well layer 24 that are arranged in the second direction, and the quantum well layer 24 of the third chip structure 203' includes the blue quantum well layer 241, the green quantum well layer 242 located on a side of the blue quantum well layer 241 away from the n-type semiconductor layer 21, and the red quantum well layer 243 located on a side of the green quantum well layer 242 away from the n-type semiconductor layer 21, and a surface of the blue quantum well layer 241 of the first chip structure 201' away from the n-type semiconductor layer 21, a surface of the green quantum well layer 242 of the second chip structure 202' away from the n-type semiconductor layer 21, and a surface of the red quantum well layer 243 of the third chip structure 203' away from the n-type semiconductor layer 21 are flush.

Specifically, the first chip structure 201' includes a metal bonding layer 43, a reflective layer 42, a first transparent conductive layer 41, a p-type ohmic contact layer 33, a hole providing layer 322, an electron blocking layer 321, a fourth u-GaN layer 31, a blue quantum well layer 241, a u-In_{x‴}Ga_{1-x‴}N/u-In_{y‴}Ga_{1-y‴}N superlattice layer 23, a second u-GaN layer 22, an n-AlGaN/n-GaN superlattice layer 212, and an n⁺⁺-GaN heavily doped layer 211 that are sequentially arranged in the second direction; the second chip structure 202' includes a metal bonding layer 43, a reflective layer 42, a first transparent conductive layer 41, a p-type ohmic contact layer 33, a hole providing layer 322, an electron blocking layer 321, a fourth u-GaN layer 31, a green quantum well layer 242, a blue quantum well layer 241, a u-In_{x‴}Ga_{1-x‴}N/u-In_{y‴}Ga_{1-y‴}N superlattice layer 23, a second u-GaN layer 22, an n-AlGaN/n-GaN superlattice layer 212, and an n⁺⁺-GaN heavily doped layer 211 that are sequentially arranged in the second direction; the third chip structure 203' includes a metal bonding layer 43, a reflective layer 42, a first transparent conductive layer 41, a p-type ohmic contact layer 33, a hole providing layer 322, an electron blocking layer 321, a fourth u-GaN layer 31, a red quantum well layer 243, a green quantum well layer 242, a blue quantum well layer 241, a u-In_{x‴}Ga_{1-x‴}N/u-In_{y‴}Ga_{1-y‴}N superlattice layer 23, a second u-GaN layer 22, an n-AlGaN/n-GaN superlattice layer 212, and an n⁺⁺-GaN heavily doped layer 211 that are sequentially arranged in the second direction.

In some embodiments, as shown in Fig. 16, the first chip structure 201', the second chip structure 202', and the third chip structure 203' may each be trapezoidal, that is, the metal bonding layer 43, the reflective layer 42, the first transparent conductive layer 41, the p-type ohmic contact layer 33, the hole providing layer 322, the electron blocking layer 321, the fourth u-GaN layer 31, the quantum well layer 24, the u-In_{x‴}Ga_{1-x‴}N/u-In_{y‴}Ga_{1-y‴}N superlattice layer 23, the second u-GaN layer 22, the n-AlGaN/n-GaN superlattice layer 212, and the n⁺⁺-GaN heavily doped layer 211 therein are each trapezoidal, and their lengths in the first direction gradually decrease in a direction from the n-type semiconductor layer 21 to the quantum well layer 24.

In addition, as shown in Fig. 14 to Fig. 16, a surface of the n-type semiconductor layer 21 of the first chip structure 201' away from the quantum well layer 24 (that is, a surface of the n⁺⁺-GaN heavily doped layer 211 away from the quantum well layer 24), a surface of the n-type semiconductor layer 21 of the second chip structure 202' away from the quantum well layer 24 (that is, a surface of the n⁺⁺-GaN heavily doped layer 211 away from the quantum well layer 24), and a surface of the n-type semiconductor layer 21 of the third chip structure 203' away from the quantum well layer 24 (that is, a surface of the n⁺⁺-GaN heavily doped layer 211 away from the quantum well layer 24) are flush.

A thickness of the n⁺⁺-GaN heavily doped layer 211 of the first chip structure 201' is smaller than a thickness of the n⁺⁺-GaN heavily doped layer 211 of the second chip structure 202', and the thickness of the n⁺⁺-GaN heavily doped layer 211 of the second chip structure 202' is smaller than a thickness of the n⁺⁺-GaN heavily doped layer 211 of the third chip structure 203' (as shown in Fig. 14).

For the film layers (such as the n-AlGaN/n-GaN superlattice layer 212, the second u-GaN layer 22, and the u-In_{x‴}Ga_{1-x‴}N/u-In_{y‴}Ga_{1-y‴}N superlattice layer 23) located between the n⁺⁺-GaN heavily doped layer 211 and the quantum well layer 24, thicknesses of the film layers of every two of the first chip structure 201', the second chip structure 202', and the third chip structure 203' are basically equal, which is also equal to the thickness of the film layer in the first sub-unit 201, the thickness of the film layer in the second sub-unit 202, and the thickness of the film layer in the third sub-unit 203.

During specific implementation, a surface of the n++-GaN heavily doped layer 211 away from the quantum well layer 24 in the full-color Micro-LED chip may be modified by a chemical polishing process or the like to repair and flatten it (in the full-color Micro-LED chip, at this time, a surface of the n⁺⁺-GaN heavily doped layer 211 of the first sub-unit 201 away from the quantum well layer 24, a surface of the n⁺⁺-GaN heavily doped layer 211 of the second sub-unit 202 away from the quantum well layer 24, and a surface of the n⁺⁺-GaN heavily doped layer 211 of the third sub-unit 203 away from the quantum well layer 24 are flush); then, gaps 90 may be etched between every two of the first sub-unit 201, the second sub-unit 202, and the third sub-unit 203 of the full-color Micro-LED chip by an etching process (as shown in Fig. 15), and then the isolation layers 9 are formed in the gaps 90 (as shown in Fig. 16), so that the functional layer of the first sub-unit 201 forms the functional layer of the first chip structure 201', the functional layer of the second sub-unit 202 forms the functional layer of the second chip structure 202', and the functional layer of the third sub-unit 203 forms the functional layer of the third chip structure 203'.

In addition, as shown in Fig. 16, in the epitaxial structure, a passivation layer 6 and a second transparent conductive layer 7 are sequentially arranged on a surface of each of the first chip structure 201', the second chip structure 202', and the third chip structure 203', and the second transparent conductive layer 7 penetrates through the passivation layer 6 to be connected to the n-type semiconductor layer 21 (specifically, to be connected to the n⁺⁺-GaN heavily doped layer 211).

Specifically, for each chip structure, the passivation layer 6 on the surface of the chip structure includes a first passivation portion 61 located on a side of the n-type semiconductor layer 21 away from the quantum well layer 24, and a second passivation portion 62 disposed on a side wall of the chip structure, and an end of the second passivation portion 62 away from the first passivation portion 61 extends outward in the first direction (in a direction away from the chip structure on which the second passivation portion 62 is located) to form a first extension portion 63, that is, the first extension portion 63 and the first passivation portion 61 are respectively located on two opposite sides of the second passivation portion 62 in the second direction, and an extension direction of the first extension portion 63 is basically parallel to the first direction.

Specifically, for each chip structure, the first extension portion 63 of the passivation layer 6 on the surface of the chip structure may be in direct contact with the pixel driving circuit element 5, and an outer edge of the first extension portion 63 in the first direction (that is, an edge of a side of the first extension portion 63 away from the second passivation portion 62) does not exceed an outer edge of the pixel driving circuit element 5 in the first direction.

In addition, for each chip structure, the second transparent conductive layer 7 on the surface of the chip structure includes a first layer portion 71 located on a side of the passivation layer 6 away from the n-type semiconductor layer 21 in the second direction, and a second layer portion 72 disposed on the side wall of the chip structure, and an end of the second layer portion 72 away from the first layer portion 71 extends outward in the first direction to form a second extension portion 73, that is, the second extension portion 73 and the first layer portion 71 are respectively located on two opposite sides of the second layer portion 72 in the second direction, and an extension direction of the second extension portion 73 is basically parallel to the first direction.

The second transparent conductive layer 7 further includes a third extension portion 74 connected to the first layer portion 71, and the third extension portion 74 penetrates through the first passivation portion 61 of the passivation layer 6 to be connected to the n-type semiconductor layer 21. The third extension portion 74 may be specifically arranged in a middle position of the first layer portion 71 in the first direction.

In addition, as shown in Fig. 16, for each chip structure, the second transparent conductive layer 7 on the surface of the chip structure is covered by the isolation layer 9, and taking a surface of the pixel driving circuit element 5 facing the chip structure as a reference, the height of the isolation layer 9 is higher than the height of the second transparent conductive layer 7.

In addition, as shown in Fig. 16, the second extension portion 73 of the second transparent conductive layer 7 is located on a side of the first extension portion 63 of the passivation layer 6 away from the pixel driving circuit element 5, there may be a gap between the second extension portion 73 of the second transparent conductive layer 7 and the first extension portion 63 of the passivation layer 6, and the gap is filled with the isolation layer 9.

In addition, the above epitaxial structure further includes an n-type ohmic contact electrode 8 connected to the second transparent conductive layer 7, specifically, there are a plurality of n-type ohmic electrodes, so that the second transparent conductive layer 7 on the surface of each chip structure (that is, each first chip structure 201', each second chip structure 202', and each third chip structure 203') is connected to the n-type ohmic contact electrode, and the n-type ohmic contact electrodes of every two chip structures may be spaced apart by the isolation layer 9.

Continuing to refer to Fig. 16, for each chip structure, the n-type ohmic contact electrode 8 may be arranged on the second extension portion 73 of the second transparent conductive layer 7 and extends outward in a direction away from the second extension portion 73 in the second direction, and a surface of the n-type ohmic contact electrode 8 away from the second extension portion 73 may be basically flush with a surface of the isolation layer 9 away from the pixel driving circuit element 5.

The full-color Micro-LED display apparatus provided by the embodiment of the present disclosure is formed by using the above-mentioned full-color Micro-LED chip, and as mentioned above, the embodiment of the present disclosure may simultaneous achieve monolithic integration of RGB full-color Micro-LED display apparatuses, and has advantages such as a simple preparation process, which is favorable for practical industrial application.

An embodiment of the present disclosure further provides a preparation method of the above full-color Micro-LED chip, as shown in Fig. 1 to Fig. 11, the preparation method of the full-color Micro-LED chip includes the following steps S1 to S4.

S1: providing a base substrate for forming the substrate layer 1, where the base substrate includes a layer to be patterned, the layer to be patterned has a first side surface and a second side surface that are opposite, and a direction from the first side surface to the second side surface is parallel to the second direction; performing patterning processing on the first side surface of the layer to be patterned to form at least one mesa group, each mesa group includes a first mesa 101, a second mesa 102, and a third mesa 103 that are distributed in the first direction, and taking the second side surface of the layer to be patterned as a reference, a height of the first mesa 101 is greater than a height of the second mesa 102, and the height of the second mesa 102 is greater than a height of the third mesa 103; where the layer to be patterned is formed into a patterned layer after the patterning processing.

In some embodiments, as shown in Fig. 1 to Fig. 5, the above preparation process may specifically include the following steps S11 to S14.

S11: growing a dielectric layer 12 on a substrate 11.

During specific implementation, a plasma enhanced chemical vapor deposition (PECVD) system or an atomic layer deposition (ALD) device may be used to grow a SiO₂ film layer or a SiNₓ film layer to form the dielectric layer 12, and as mentioned above, a thickness of the dielectric layer 12 may be 20 nm to 40 nm.

S12: etching the dielectric layer 12 to form a third groove 130 that exposes the substrate 11 (that is, an etching depth is equal to the thickness of the dielectric layer 12), and the dielectric layer 12 that is not etched is annularly arranged on a peripheral side of the third groove 130 (as shown in Fig. 3).

During specific implementation, the dielectric layer 12 may be exposed and developed to expose a region to be etched, and then the dielectric layer 12 is etched to form the third groove 130. When the dielectric layer 12 is a SiO₂ film layer, etching may be performed by a BOE wet etching method, so as to remove the SiO₂ film layer in the region to be etched and form the third groove 130; when the dielectric layer 12 is a SiNₓ film layer, etching may be performed by an ICP-RIE dry etching method, so as to remove the SiNₓ film layer in the region to be etched and form the third groove 130.

After the etching is finished, the photoresist may be removed by an acetone solution, then the substrate 11 on which the dielectric layer 12 is formed is cleaned by ethanol and water, and then dried by an inert gas (such as nitrogen), and then the subsequent process is performed. The water used may be deionized water, but it is not limited thereto.

S13: growing a buffer layer 13 in the third groove 130 (as shown in Fig. 4).

During specific implementation, when the substrate 11 is a sapphire substrate 11, a magnetron sputtering coating (PVD) device may be used to deposit an AlN buffer layer; when the substrate 111 is a silicon substrate 11, generally, MOVCD may be used to grow the AlN buffer layer at a high and low temperature, or the AlN buffer layer may be grown at a high and low temperature after pre-passing an Al source (for example, when growing the AlN buffer layer, trimethylaluminum (an aluminum source) may be pre-passed into a chamber for growing the AlN buffer layer, and then trimethylaluminum and ammonia gas are simultaneously passed into the chamber to grow the AlN buffer layer).

S14: growing a first u-GaN layer 14 on the dielectric layer 12 and the buffer layer 13 (as shown in Fig. 5).

Specifically, a metal organic chemical vapor deposition (MOCVD) system may be used to epitaxially grow the first u-GaN layer 14.

In addition, when the substrate 11 is a silicon substrate 11, the above preparation method may further include: after growing the buffer layer 13 on the substrate 11 (before growing the first u-GaN layer 14), first growing the stress control layer on the buffer layer 13, and then growing the first u-GaN layer 14 on the stress control layer.

As mentioned above, the stress control layer may be an AlGaN layer, and the Al component in the AlGaN layer has a decreasing trend in a direction away from the buffer layer 13 in the second direction, and the decreasing trend may be a gradient decrease or a linear gradual decrease (that is, the stress control layer may be a linearly graded AlGaN layer), for example, an Al_{0.8}Ga_{0.2}N layer, an Al_{0.6}Ga_{0.4}N layer, and an Al_{0.3}Ga_{0.7}N layer may be sequentially grown on the buffer layer 13 to form the stress control layer; or a linearly graded AlGaN layer is grown, in which the Al component content may be linearly graded to 0 in the direction away from the buffer layer 13 in the second direction.

Specifically, the base substrate includes the above substrate 11, and the layer to be patterned may be the substrate 11 that is not patterned or the first u-GaN layer 14 formed on the substrate 11.

When the layer to be patterned is the substrate 11 that is not patterned, the substrate 11 is patterned to form the above mesa, and then the dielectric layer 12, the buffer layer 13, the first u-GaN layer 14 and other film layers are grown on a side of the substrate 11 on which the mesa is formed (that is, the first side surface) to form the above substrate layer 1, and then the n-type semiconductor layer 21, the quantum well layer 24 and other film layers are sequentially grown on the substrate layer 1 to obtain the full-color Micro-LED chip (as shown in Fig. 1 to Fig. 11).

When the layer to be patterned is the first u-GaN layer 14 formed on the substrate 11, first, the dielectric layer 12, the buffer layer 13 and other film layers between the substrate 11 and the first u-GaN layer 14 are grown on the substrate 11, and then the first u-GaN layer 14 is grown, and then the first u-GaN layer 14 is patterned to form the above mesa, thereby forming the substrate layer 1, and then the n-type semiconductor layer 21, the quantum well layer 24 and other film layers are sequentially grown on a side of the substrate layer 1 on which the mesa is formed (that is, the first side surface of the patterned layer) to obtain the full-color Micro-LED chip.

Specifically, the above patterning process may include the following steps S15 to S16.

S15: as shown in Fig. 1, etching the layer to be patterned (the substrate 11) to form a first groove 110; the first groove 110 has a side wall and a bottom wall, and a surface of the side wall away from the bottom wall in the second direction is the first mesa 101.

The etching of the layer to be patterned to form the first groove 110 may specifically include: after spin-coating 1.5 µm to 3 µm of photoresist on the layer to be patterned, exposing a region to be etched through an exposure and development process, and then etching through an inductively coupled plasma etching method to form the first groove 110.

Specifically, an etching pattern (that is, a shape of an orthographic projection of the first groove 110 on the substrate 11) may be rectangular, a length of the etching pattern may be 5 mm to 14 mm, a width of the etching pattern may be 1.9 mm to 4.1 mm, and a depth of the first groove 110 may be 36 nm to 54 nm.

S16: as shown in Fig. 2, etching a partial region (that is, a region for forming the third mesa 103) of the bottom wall of the first groove 110 to form a second groove 120; a surface of a region of the bottom wall of the first groove 110 that is not etched is the second mesa 102, and a bottom surface of the second groove 120 is the third mesa 103.

The etching of the partial region of the bottom wall of the first groove 110 to form the second groove 120 may specifically include: after spin-coating 1.5 µm to 3 µm of photoresist on the layer to be patterned in which the first groove 110 is formed, exposing a region to be etched through an exposure and development process, and then etching through an inductively coupled plasma etching method to form the second groove 120.

An etching pattern (that is, a shape of the second groove 120) may be rectangular, a length of the etching pattern may be 2.5 mm to 7 mm, a width of the etching pattern may be 1.9 mm to 4.1 mm, and a depth of the second groove 120 may be 39 nm to 60 nm.

Under normal circumstances, in the above steps S15 and S16, after the etching is finished, the photoresist may be removed by the acetone solution, then the layer to be patterned is cleaned by ethanol and water, and then dried by an inert gas (such as nitrogen), and then the subsequent process is performed. The water used may be deionized water, but it is not limited thereto.

In the embodiment of the present disclosure, a conventional inductively coupled plasma etching device (ICP-RIE) in the art may be used for etching by the inductively coupled plasma etching method.

S2: as shown in Fig.6 to Fig. 8, epitaxially growing an n-type semiconductor layer 21 and a quantum well layer 24 in sequence on the first side surface of the patterned layer, where the quantum well layer 24 includes a blue quantum well layer 241, a green quantum well layer 242, and a red quantum well layer 243 that are sequentially grown on the n-type semiconductor layer 21, and a surface of the blue quantum well layer 241 located on the first mesa 101 away from the n-type semiconductor layer 21, a surface of the green quantum well layer 242 located on the second mesa 102 away from the n-type semiconductor layer 21, and a surface of the red quantum well layer 243 located on the third mesa 103 away from the n-type semiconductor layer 21 are flush, so as to form a flush quantum well surface.

As mentioned above, the n-type semiconductor layer 21 may include an n⁺⁺-GaN heavily doped layer 211 and an n-AlGaN/n-GaN superlattice layer 212 that are sequentially arranged in a direction from the substrate 11 to the quantum well layer 24. During specific implementation, the n⁺⁺-GaN heavily doped layer 211 may be deposited on a side of the first u-GaN layer 144 away from the substrate 11, and then the n-AlGaN/n-GaN superlattice layer 212 of 5 to 10 periods is deposited, and the formation of the n-AlGaN/n-GaN superlattice layer 212 may further reduce the extension of dislocations in the material during the heavy doping process (that is, the formation process of the n⁺⁺-GaN heavily doped layer 211) and control the stress.

Under normal circumstances, the first u-GaN layer 14 and the n-type semiconductor layer 21 (the n⁺⁺-GaN heavily doped layer 211 and the n-AlGaN/n-GaN superlattice layer 212) are grown in a hydrogen atmosphere, the quantum well layer 24 is grown in a nitrogen atmosphere, and the growth temperature of the quantum well layer 24 is lower than the growth temperature of these film layers. During specific implementation, the above preparation method may further include: after the growth of the n-type semiconductor layer 21 is finished (specifically, after the growth of the n-AlGaN/n-GaN superlattice layer 212 is finished), growing a second u-GaN layer 22 on the n-type semiconductor layer 21 (specifically, on the n-AlGaN/n-GaN superlattice layer 212) in the nitrogen atmosphere, and then growing the quantum well layer 24 on the second u-GaN layer 22 (as shown in Fig. 7).

The thickness of the second u-GaN layer 22 may be 10 nm to 20 nm, for example, 10 nm, 11 nm, 12 nm, 13 nm, 14 nm, 15 nm, 16 nm, 17 nm, 18 nm, 19 nm, 20 nm, or a range composed of any two of them.

Specifically, the first u-GaN layer 14 and the n-type semiconductor layer 21 (the n⁺⁺-GaN heavily doped layer 211 and the n-AlGaN/n-GaN superlattice layer 212) may be epitaxially grown by MOCVD at a growth temperature of about 1040°C to 1080°C and in the hydrogen atmosphere. Before growing the quantum well structure (the quantum well layer 24), it is necessary to switch the chamber atmosphere, that is, switch hydrogen to nitrogen, and at the same time, it is necessary to reduce the film layer growth temperature. After the growth of the above n-AlGaN/n-GaN superlattice layer 212 is finished, by first growing the second u-GaN layer 22 with a thickness of 10 nm to 20 nm in the nitrogen atmosphere, problems such as film layer etching in a high-temperature hydrogen atmosphere and deterioration of surface flatness of the subsequent quantum well structure caused thereby may be avoided.

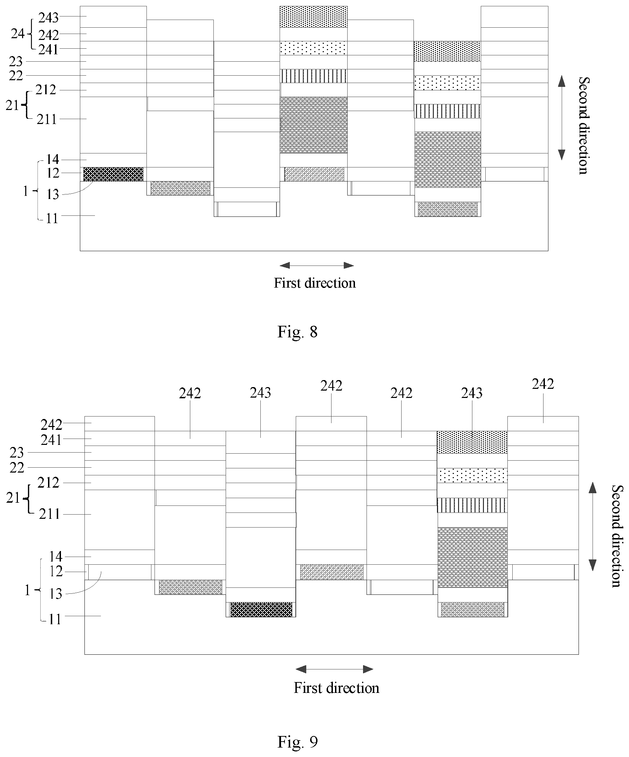

In addition, as shown in Fig. 7 and Fig. 8, it is also possible to first grow a u-In_{x‴}Ga_{1-x‴}N/u-In_{y‴}Ga_{1-y‴}N superlattice layer 23 of 5 to 10 periods on the second u-GaN layer 22, and then grow the quantum well layer 24 on the u-In_{x‴}Ga_{1-x‴}N/u-In_{y‴}Ga_{1-y‴}N superlattice layer 23, where 0.01≤x‴≤0.1, y‴=0 or 0.005≤ y‴≤0.01, which may block dislocations to control stress and realize a lattice transition before the growth of the quantum well layer 24 (RGB quantum well).

S3: as shown in Fig. 9 and Fig. 10, removing the green quantum well layer 242 and the red quantum well layer 243 located on the first mesa 101 and the red quantum well layer 243 located on the second mesa 102 through a first etching process to expose the flush quantum well surface, thereby forming at least one unit group 200 on the substrate layer 1, each unit group 200 includes a first sub-unit 201 located on the first mesa 101, a second sub-unit 202 located on the second mesa 102, and a third sub-unit 203 located on the third mesa 103.

As mentioned above, the red quantum well layer 243 includes a third potential well layer and a third potential barrier layer, and after the growth of the quantum well layer 24 is finished (specifically, after the growth of the red quantum well layer 243 is finished), a third u-GaN layer is grown on the quantum well layer 24 (specifically, a side of the red quantum well layer 243 away from the substrate 11) under the growth conditions of the third potential barrier layer, and then the temperature is reduced, the third u-GaN layer is at least partially decomposed during the temperature reduction process, and then the first etching process is performed.

Specifically, the growth of the film layers such as the above quantum well layer 24 is carried out in a reaction chamber, and as mentioned above, the quantum well layer 24 is grown in a nitrogen atmosphere, and after the growth is finished, the temperature is reduced and the quantum well layer 24 is taken out from the reaction chamber, and then the quantum well layer 24 is etched through the first etching process to expose the flush quantum well surface. After the growth of the quantum well layer 24 is finished, the third u-GaN layer is epitaxially grown on the quantum well layer 24 first, and then the temperature is reduced in the nitrogen atmosphere and is taken out from the reaction chamber, and the third u-GaN layer is at least partially etched and decomposed during the temperature reduction process. Therefore, the third u-GaN layer acts as a protective layer to protect the quantum well layer 24 and avoid the influence of the temperature reduction process on the quantum well layer 24.

Specifically, the thickness of the third u-GaN layer may be 10 nm to 20 nm, for example, 10 nm, 11 nm, 12 nm, 13 nm, 14 nm, 15 nm, 16 nm, 17 nm, 18 nm, 19 nm, 20 nm, or a range composed of any two of them.

Specifically, the process of the first etching process may include the following steps S31 to S32, that is, after etching the red quantum well layer 243 corresponding to the first mesa 101 and the second mesa 102 through the step S31, the green quantum well layer 242 corresponding to the first mesa 101 is etched through the step S32.

S31: after coating 1.5 µm to 3 µm of photoresist on a surface of the quantum well layer 24, exposing a region to be etched through an exposure and development process (that is, exposing the red quantum well layer 243 corresponding to the first mesa 101 and the red quantum well layer 243 corresponding to the second mesa 102), and then etching away the red quantum well layer 243 corresponding to the first mesa 101 and the red quantum well layer 243 corresponding to the second mesa 102 through an inductively coupled plasma etching method (that is, etching the epitaxial layer by ICP-RIE), to expose the green quantum well layer 242 corresponding to the first mesa 101 and the green quantum well layer 242 corresponding to the second mesa 102 (as shown in Fig. 9).

An etching depth, a height difference ΔH₂ between the second mesa 102 and the third mesa 103, and a thickness of the red quantum well layer 243 are equal, that is, the etching depth is about 39 nm to 60 nm, and after the etching is finished, the photoresist may be removed by an acetone solution, then cleaned by ethanol and water, and then dried by an inert gas (such as nitrogen), and then the subsequent process (that is, step S32) is performed. The water used may be deionized water, but it is not limited thereto.

S32: after coating 1.5 µm to 3 µm of photoresist on the quantum well layer 24 again, exposing a region to be etched through an exposure and development process (that is, exposing the green quantum well layer 242 corresponding to the first mesa 101), and then etching away the green quantum well layer 242 corresponding to the first mesa 101 through an inductively coupled plasma etching method (that is, etching the epitaxial layer by ICP-RIE) to expose the blue quantum well layer 241 corresponding to the first mesa 101, thereby exposing the flush quantum well surface (as shown in Fig. 10).

An etching depth, a height difference ΔH₁ between the first mesa 101 and the second mesa 102, and a thickness of the green quantum well layer 242 are equal, that is, the etching depth is about 36 nm to 54 nm, and after the etching is finished, the photoresist may be removed by an acetone solution, then cleaned by ethanol and water, and then dried by an inert gas (such as nitrogen), and then the subsequent process (that is, step S4) is performed. The water used may be deionized water, but it is not limited thereto.

S4: after exposing the flush quantum well surface, sequentially growing a fourth u-GaN layer 31, an electron blocking layer 321, a hole providing layer 322, and a p-type ohmic contact layer 33 on the flush quantum well surface (as shown in Fig. 11) to obtain the LED full-color Micro-LED chip.

Specifically, after exposing the flush quantum well surface, the prepared full-color Micro-LED chip precursor is put into the reaction chamber, and the fourth u-GaN layer 31 is grown on the flush quantum well surface in the nitrogen atmosphere; then the hydrogen atmosphere is switched, and the temperature is raised to grow the electron blocking layer 321, that is, the electron blocking layer 321 is grown on the fourth u-GaN layer 31 in the hydrogen atmosphere, and the growth temperature of the electron blocking layer 321 is higher than the growth temperature of the fourth u-GaN layer 31.

Specifically, the thickness of the fourth u-GaN layer 31 may be 20 nm to 30 nm, for example, 20 nm, 21 nm, 22 nm, 23 nm, 24 nm, 25 nm, 26 nm, 27 nm, 28 nm, 29 nm, 30 nm, or a range composed of any two of them.

An embodiment of the present disclosure further provides a preparation method of the above full-color Micro-LED display apparatus, as shown in Fig. 12 to Fig. 16, the preparation method of the full-color Micro-LED display apparatus includes the following steps S5 and S6.

S5: providing the aforementioned full-color Micro-LED chip (as shown in Fig. 11), or preparing a full-color Micro-LED chip according to the above preparation method of the full-color Micro-LED chip (as shown in Fig. 1 to Fig. 11), which will not be repeated herein.

S6: bonding the full-color Micro-LED chip to a pixel driving circuit element 5 to obtain a full-color Micro-LED display apparatus (as shown in Fig. 12 to Fig. 16).

In the embodiments of the present disclosure, the full-color Micro-LED chip may be bonded to the pixel driving circuit element 5 through a conventional standard semiconductor process flow in the art to obtain the full-color Micro-LED display apparatus. In some specific embodiments, the process of bonding the full-color Micro-LED chip to the pixel driving circuit element 5 may include the following steps S61 to S67.

S61: sequentially growing a first transparent conductive layer 41, a reflective layer 42, and a metal bonding layer 43 on the p-type ohmic contact layer 33 (as shown in Fig. 12).

S62: bonding the metal bonding layer 43 to the pixel driving circuit element 5, that is, bonding the full-color Micro-LED chip to the pixel driving circuit element 5 through the metal bonding layer 43 (as shown in Fig. 12).

S63: removing the substrate layer 1, that is, removing the substrate 11, the first u-GaN layer 14, and the film layers (such as the above dielectric layer 12 and buffer layer 13) located between the substrate 11 and the first u-GaN layer 14 to expose the n-type semiconductor layer 21, specifically expose the n⁺⁺-GaN heavily doped layer 211 (as shown in Fig. 13), and the n⁺⁺-GaN heavily doped layers 211 of the first sub-unit 201, the second sub-unit 202, and the third sub-unit 203 are all exposed.

S64: modifying a surface of the n-type semiconductor layer 21 of the full-color Micro-LED chip away from the quantum well layer 24 (specifically, a surface of the n⁺⁺ heavily doped layer 211 away from the quantum well layer 24) to make that a surface of the n-type semiconductor layer 21 of the first sub-unit 201 away from the quantum well layer 24, a surface of the n-type semiconductor layer 21 of the second sub-unit 202 away from the quantum well layer 24, and a surface of the n-type semiconductor layer 21 of the third sub-unit 203 away from the quantum well layer 24 are flush (as shown in Fig. 14);

S65: forming gaps 90 between every two adjacent ones of the first sub-unit 201, the second sub-unit 202, and the third sub-unit 203 through a second etching process to form a first chip structure 201' corresponding to the first sub-unit 201, a second chip structure 202' corresponding to the second sub-unit 202, and a third chip structure 203' corresponding to the third sub-unit 203 (as shown in Fig. 15).

The gaps 90 extend from the n⁺⁺-GaN heavily doped layer 211 to the metal bonding layer 43 and penetrate through the n⁺⁺-GaN heavily doped layer 211 and the metal bonding layer 43, that is, the gaps 90 end at a surface of the pixel driving circuit element 5 facing the metal bonding layer 43.

Specifically, as shown in Fig. 11, in the full-color Micro-LED chip, every two adjacent ones of the first sub-unit 201, the second sub-unit 202, and the third sub-unit 203 are in direct contact, and there is no isolation structure such as a gap or a film layer between the two, and through the second etching process, the first sub-unit 201, the second sub-unit 202, and the third sub-unit 203 are respectively partially etched, where the n⁺⁺-GaN heavily doped layer 211, the n-AlGaN/n-GaN superlattice layer 212, the second u-GaN layer 22, the u-In_{x‴}Ga_{1-x‴}N/u-In_{y‴}Ga_{1-y‴}N superlattice layer 23, the blue quantum well layer 241, and at the same time the fourth u-GaN layer 31, the electron blocking layer 321, the hole providing layer 322, the p-type ohmic contact layer 33, the first transparent conductive layer 41, the reflective layer 42, and the metal bonding layer 43 are also respectively partially etched (that is, the n⁺⁺-GaN heavily doped layer 211, the metal bonding layer 43, and the film layer located between the n⁺⁺-GaN heavily doped layer 211 and the metal bonding layer 43 are all respectively partially etched), so as to form the first chip structure (blue chip structure B) 201' corresponding to the first sub-unit 201, the second chip structure (green chip structure G) 202' corresponding to the second sub-unit 202, the third chip structure (red chip structure R) 203' corresponding to the third sub-unit 203, and the gaps 90 spaced between every two adjacent ones of the first chip structure 201', the second chip structure 202', and the third chip structure 203'.

S66: forming isolation layers 9 in the gaps 90, to make that every two adjacent ones of the first chip structure 201', the second chip structure 202', and the third chip structure 203' are spaced apart by the isolation layers, and sequentially forming a passivation layer 6 and a second transparent conductive layer 7 on each of a surface of the first chip structure 201', a surface of the second chip structure 202', and a surface of the third chip structure 203', and making the second transparent conductive layer 7 penetrate through the passivation layer 6 to be connected to the n-type semiconductor layer 21 (specifically, to be connected to the n⁺⁺-GaN heavily doped layer 211).

S67: then, forming an n-type ohmic contact electrode 8 connected to the second transparent conductive layer 7 to obtain the full-color Micro-LED display apparatus.

For the specific structures of the passivation layer 6, the second transparent conductive layer 7, the n-type ohmic contact electrode 8, and other structures, reference may be made to the foregoing, which will not be repeated herein.

In the embodiments of the present disclosure, the above etching, removing, depositing, and other processes may be performed by using conventional methods in the art, for example, the substrate 11 may be removed by a laser lift-off process or the like, the first u-GaN layer 14 is etched and removed by ICP-RIE or the like, and then the flatness of the surface of the n⁺⁺-GaN heavily doped layer 211 is repaired by a chemical polishing process or the like, and then the above second etching process is performed by ICP-RIE or the like according to parameters such as a preset pixel (that is, the first chip structure 201', the second chip structure 202', and the third chip structure 203') size and a spacing between adjacent pixels, so as to form the above gaps 90, and then the side walls of these film layers facing the gaps 90 are passivated and repaired, the passivation layer 6 is deposited, the chip structures are isolated, and then the second transparent conductive layer 7 and the n-type ohmic contact layer are deposited to obtain the full-color Micro-LED display apparatus.

Unless otherwise specified, the above film layers or structures may be made of conventional materials in the art, which is not particularly shown.

Exemplarily, the first transparent conductive layer 41 may include indium tin oxide (ITO), which may be specifically an ITO film layer.

Exemplarily, the second transparent conductive layer 7 may include indium tin oxide (ITO), which may be specifically an ITO film layer.

Exemplarily, the reflective layer 42 may include silver (Ag), which may be specifically a silver highly reflective layer 42, and during specific implementation, a silver highly reflective material may be deposited by using an electron beam evaporation apparatus to form the reflective layer 4215.

In addition, the thickness of the reflective layer 42 may be 80 nm to 200 nm, for example, 80 nm, 100 nm, 120 nm, 140 nm, 150 nm, 160 nm, 180 nm, 200 nm, or a range composed of any two of them.

Exemplarily, the metal bonding layer 43 includes a metal, for example, the metal includes one or more of nickel (Ni), titanium (Ti), Ag, and the like. Exemplarily, the metal bonding layer 43 may include a nickel layer, a titanium layer, a nickel layer, and a silver layer that are sequentially stacked on the reflective layer 42.

Exemplarily, the pixel driving circuit element 5 may be a silicon-based pixel driving circuit element 5, which may specifically include a silicon-based complementary metal oxide semiconductor (CMOS) chip.

Exemplarily, the isolation layer 9 may include SiO₂, which may be specifically a SiO₂ film layer formed of SiO₂.

In the embodiments of the present disclosure, the layer to be patterned (such as the substrate 11) is patterned to achieve a thickness gradient change of the formed patterned layer (that is, to form at least one mesa group, each mesa group includes a first mesa 101, a second mesa 102, and a third mesa 103 with sequentially decreasing heights), and then functional layers such as the n-type semiconductor layer 21 and the RGB quantum well layer 24 are epitaxially grown on the patterned layer, and a surface of the blue quantum well layer 241 corresponding to the first mesa 101, a surface of the green quantum well layer 242 corresponding to the second mesa 102, and a surface of the red quantum well layer 243 corresponding to the third mesa 103 away from the n-type semiconductor layer 21 are kept flush, so as to form a flush quantum well surface, and then the planarization is achieved by using an etching process (first etching process), and then the first chip structure 201' corresponding to the first sub-unit, the second chip structure 202' corresponding to the second sub-unit 202, and the third chip structure 203' corresponding to the third sub-unit 203 are respectively formed through the second etching process, to respectively form the RGB full-color Micro-LED display apparatus (that is, the first chip structure 201', the second chip structure 202', and the third chip structure 203').

Therefore, in the embodiments of the present disclosure, through the preparation process of the full-color Micro-LED chip, it is possible to achieve RGB three-primary-color light emission (that is, to achieve RGB full-color light emission) of a single substrate (such as a sapphire substrate or a silicon substrate), for example, to achieve RGB three-primary-color light emission of an InGaN material of a single substrate, that is, it is possible to simultaneously prepare RGB LED chip structures, to achieve simultaneous monolithic integration of RGB Micro-LED chips, to obtain the full-color Micro- full-color Micro-LED chip and the display apparatus, and the method has advantages such as a simple preparation process and cost saving.

In the description of the present disclosure, "n-" or "n⁺⁺" means n-type doping, for example, the aforementioned n⁺⁺-GaN heavily doped layer 211 and the n-AlGaN/n-GaN superlattice layer 212 both mean n-type doped layers, and conventional dopants in the art may be used, for example, the dopant includes SiH₄; "p-" or "p⁺⁺" means p-type doping, for example, the aforementioned p⁺⁺-GaN heavily doped layer, the p-AlGaN/p-GaN superlattice layer, etc. both mean p-type doped layers, and conventional dopants in the art may also be used for them; "u-" means undoped, for example, the aforementioned u-GaN layer means an undoped gallium nitride film layer, etc. In addition, unless otherwise specified, the "content" refers to a molar content, and a thickness direction of the "thickness" as described above is parallel to the second direction. The arrangement in the second direction (such as being stacked along the second direction, being stacked in sequence along the second direction, etc.) may be specifically arranged in a direction from the n-type semiconductor layer 21 (or the substrate layer 1) to the quantum well layer 24, or arranged in a direction from the quantum well layer 24 to the n-type semiconductor layer 21 (or the substrate layer 1).

In addition, terms such as "first" and "second" are only used for descriptive purposes, for example, to distinguish various components, so as to more clearly illustrate/explain the technical solution, and cannot be understood as indicating or implying the number of technical features indicated or having a substantial meaning of order and other meanings.

Finally, it should be noted that the above embodiments are only used to illustrate the technical solution of the present disclosure, rather than limiting it; although the present disclosure has been described in detail with reference to the aforementioned embodiments, those of ordinary skills in the art should understand that they may still modify the technical solution recorded in each of the aforementioned embodiments, or equivalently replace some or all of technical features; and these modifications or replacements do not make the essence of the corresponding technical solution depart from the scope of the technical solution of each embodiment of the present disclosure.

## Claims

1. A full-color Micro-LED chip, comprising:
a substrate layer; and
a functional layer, disposed on the substrate layer, wherein the functional layer comprises an n-type semiconductor layer and a quantum well layer that are arranged in a stacked manner in a second direction; the functional layer comprises at least one unit group, each unit group comprises a first sub-unit, a second sub-unit, and a third sub-unit that are distributed in a first direction, and the first direction intersects with the second direction;
the quantum well layer of the first sub-unit comprises a blue quantum well layer;
the quantum well layer of the second sub-unit comprises a blue quantum well layer and a green quantum well layer that are sequentially arranged in a stacked manner on the n-type semiconductor layer in the second direction;
the quantum well layer of the third sub-unit comprises a blue quantum well layer, a green quantum well layer, and a red quantum well layer that are sequentially arranged in a stacked manner on the n-type semiconductor layer in the second direction; and
a surface of the blue quantum well layer of the first sub-unit away from the n-type semiconductor layer, a surface of the green quantum well layer of the second sub-unit away from the n-type semiconductor layer, and a surface of the red quantum well layer of the third sub-unit away from the n-type semiconductor layer are flush.

2. The full-color Micro-LED chip according to claim 1, wherein the substrate layer comprises a patterned layer located on a side of the n-type semiconductor layer away from the quantum well layer, a surface of the patterned layer facing the n-type semiconductor layer comprises at least one mesa group in one-to-one correspondence with the at least one unit group, each mesa group comprises a first mesa, a second mesa, and a third mesa that are distributed in the first direction, and taking a surface of the patterned layer away from the n-type semiconductor layer as a reference, a height of the first mesa is greater than a height of the second mesa, the height of the second mesa is greater than a height of the third mesa, the first sub-unit is located on the first mesa, the second sub-unit is located on the second mesa, and the third sub-unit is located on the third mesa.

3. The full-color Micro-LED chip according to claim 2, wherein
a height difference between the first mesa and the second mesa is equal to a thickness of the green quantum well layer;
and/or, the height difference between the first mesa and the second mesa is 36 nm to 54 nm;
and/or, a height difference between the second mesa and the third mesa is equal to a thickness of the red quantum well layer;
and/or, the height difference between the second mesa and the third mesa is 39 nm to 60 nm.

4. The full-color Micro-LED chip according to claim 2 or 3, wherein the substrate layer further comprises a substrate located on a side of the n-type semiconductor layer away from the quantum well layer, and a first u-GaN layer located between the substrate and the n-type semiconductor layer; wherein,
the patterned layer is the substrate, or the patterned layer is the first u-GaN layer;
and/or, the substrate comprises a sapphire substrate or a silicon substrate;
and/or, the substrate layer further comprises a dielectric layer and an AlN buffer layer located between the substrate and the first u-GaN layer, the dielectric layer is arranged around a peripheral side of the AlN buffer layer, and the dielectric layer comprises a silicon oxide compound and/or a silicon nitride compound.

5. The full-color Micro-LED chip according to claim 4, wherein the substrate is the silicon substrate, the substrate layer further comprises a stress control layer located between the AlN buffer layer and the first u-GaN layer, the stress control layer comprises an AlGaN layer, and Al component content in the AlGaN layer has a decreasing trend in a direction from the AlN buffer layer to the first u-GaN layer, and the decreasing trend is a gradient decrease or a linear gradual decrease.

6. The full-color Micro-LED chip according to claim 1, wherein the n-type semiconductor layer comprises an n⁺⁺-GaN heavily doped layer, and an n-AlGaN/n-GaN superlattice layer located between the n⁺⁺-GaN heavily doped layer and the quantum well layer; wherein,
Hall electron concentration of the n⁺⁺-GaN heavily doped layer is 5×10¹⁸ cm⁻³ to 2×10¹⁹ cm⁻³;
and/or, a thickness of the n⁺⁺-GaN heavily doped layer is 1.5 µm to 2.5 µm;
and/or, Hall electron concentration of the n-AlGaN/n-GaN superlattice layer is 1×10¹⁸ cm⁻³ to 1.5×10¹⁸ cm⁻³;
and/or, the n-AlGaN/n-GaN superlattice layer comprises an n-AlGaN layer and an n-GaN layer that are alternately arranged in the second direction, a thickness of the n-AlGaN layer is 2 nm to 3 nm, Al component content in the n-AlGaN layer is 2% to 8%, and a thickness of the n-GaN layer is 5 nm to 10 nm;
and/or, an amount of periods of the n-AlGaN/n-GaN superlattice layer is 5 to 10.

7. The full-color Micro-LED chip according to claim 1, wherein the functional layer further comprises a second u-GaN layer located between the n-type semiconductor layer and the quantum well layer, and a u-In_{x‴}Ga_{1-x‴}N/u-In_{y‴}Ga_{1-y‴}N superlattice layer located between the second u-GaN layer and the quantum well layer, 0.01≤x‴ ≤0.1, y‴=0 or 0.005≤y‴≤0.01, wherein,
a thickness of the second u-GaN layer is 10 nm to 20 nm;
and/or, the u-In_{x‴}Ga_{1-x‴}N/u-In_{y‴}Ga_{1-y‴}N superlattice layer comprises a u-In_{x‴}Ga_{1-x‴}N layer and a u-In_{y‴}Ga_{1-y‴}N layer that are alternately arranged in the second direction, a thickness of the u-In_{x‴}Ga_{1-x‴}N layer is 2 nm to 3 nm, and a thickness of the u-In_{y‴}Ga_{1-y‴}N layer is 5 nm to 10 nm;
and/or, an amount of periods of the u-In_{x‴}Ga_{1-x‴}N/u-In_{y‴}Ga_{1-y‴}N superlattice layer is 5 to 10.

8. The full-color Micro-LED chip according to claim 1, wherein,
the blue quantum well layer comprises 3 to 5 first repeating units, each of the first repeating units comprises a first potential well layer and a first potential barrier layer that are arranged in a stacked manner in the second direction, the first potential well layer comprises a u-InₓGa₁₋ₓN layer, 0.18≤x≤0.2, a thickness of the first potential well layer is 2 nm to 3 nm, the first potential barrier layer comprises an n-GaN layer or a u-In_{y}Ga_{1-y}N layer, 0.01≤ y≤0.03, and a thickness of the first potential barrier layer is 10 nm to 15 nm;
and/or, the green quantum well layer comprises 3 to 5 second repeating units, each of the second repeating units comprises a second potential well layer and a second potential barrier layer that are arranged in a stacked manner in the second direction, the second potential well layer comprises a u-In_{x'}Ga_{1-x'}N layer, 0.25≤x'≤0.28, a thickness of the second potential well layer is 2 nm to 3 nm, the second potential barrier layer comprises an n-GaN layer or a u-In_{y'}Ga_{1-y'}N layer, 0.03≤y'≤0.05, and a thickness of the second potential barrier layer is 10 nm to 15 nm;
and/or, the red quantum well layer comprises 3 to 5 third repeating units, each of the third repeating units comprises a third potential well layer, a third potential barrier layer, and a u-Al_{z}Ga_{1-z}N layer that are sequentially arranged in a stacked manner in the second direction, 0.1≤z≤0.25, a thickness of the u-Al_{z}Ga_{1-z}N layer is 1 nm to 2 nm, the third potential well layer comprises a u-In_{x"}Ga_{1-x"}N layer, 0.35≤x"≤0.38, a thickness of the third potential well layer is 2 nm to 3 nm, the third potential barrier layer comprises an n-GaN layer or a u-In_{y"}Ga_{1-y"}N layer, 0.05 ≤y"≤0.08, and a thickness of the third potential barrier layer is 10 nm to 15 nm.

9. The full-color Micro-LED chip according to claim 1, wherein the functional layer further comprises a fourth u-GaN layer, a p-type semiconductor layer, and a p-type ohmic contact layer that are sequentially located on a side of the quantum well layer away from the n-type semiconductor layer, and the p-type semiconductor layer comprises an electron blocking layer and a hole providing layer located between the electron blocking layer and the p-type ohmic contact layer, wherein,
the electron blocking layer comprises at least one selected from the group consisting of a p-AlGaN layer, a p-AlGaN/p-GaN superlattice layer, and a p-AlGaN polarization-induced layer with Al component content that is linearly graded in the second direction;
the hole providing layer comprises at least one selected from the group consisting of a p-GaN layer, a p-AlGaN/p-GaN superlattice layer, and a p-AlGaN polarization-induced layer with Al component content that is linearly graded in the second direction; and
the p-type ohmic contact layer comprises at least one selected from the group consisting of a p⁺⁺-GaN heavily doped layer, an ITO film layer, a p-InGaN/p-GaN superlattice layer, and a p-AlGaN polarization-induced layer with Al component content that is linearly graded in the second direction.

10. The full-color Micro-LED chip according to claim 9, wherein,
Al component content in the p-AlGaN layer of the electron blocking layer is 10% to 25%;
and/or, both the p-AlGaN/p-GaN superlattice layer of the electron blocking layer and the p-AlGaN/p-GaN superlattice layer of the hole providing layer comprise a p-AlGaN layer and a p-GaN layer, Al component content in the p-AlGaN layer of the p-AlGaN/p-GaN superlattice layer is 20% to 25%, a thickness of the p-AlGaN layer of the p-AlGaN/p-GaN superlattice layer is 2 nm to 3 nm, and a thickness of the p-GaN layer of the p-AlGaN/p-GaN superlattice layer is 5 nm to 10 nm;
and/or, the Al component content in the p-AlGaN polarization-induced layer of the electron blocking layer, the Al component content in the p-AlGaN polarization-induced layer of the hole providing layer, and the Al component content in the p-AlGaN polarization-induced layer of the p-type ohmic contact layer are respectively linearly graded from 30% to 0 in the second direction;
and/or, a thickness of the electron blocking layer is 20 nm to 60 nm;
and/or, a thickness of the p-GaN layer of the hole providing layer is 100 nm to 160 nm;
and/or, a thickness of the p-AlGaN polarization-induced layer of the electron blocking layer, a thickness of the p-AlGaN polarization-induced layer of the hole providing layer, and a thickness of the p-AlGaN polarization-induced layer of the p-type ohmic contact layer are respectively 60 nm to 80 nm;
and/or, a dopant in the p⁺⁺-GaN heavily doped layer comprises Mg;
and/or, hole Hall concentration of the p⁺⁺-GaN heavily doped layer is 2×10²⁰ cm⁻³ to 4×10²⁰ cm⁻³;
and/or, a thickness of the p⁺⁺-GaN heavily doped layer is 10 nm to 40 nm;
and/or, the p-InGaN/p-GaN superlattice layer comprises a p-InGaN layer and a p-GaN layer, a thickness of the p-InGaN layer of the p-InGaN/p-GaN superlattice layer is 2 nm to 3 nm, In component content of the p-InGaN layer is 5% to 10%, and a thickness of the p-GaN layer of the p-InGaN/p-GaN superlattice layer is 5 nm to 10 nm.

11. A full-color Micro-LED display apparatus, comprising an epitaxial structure formed by the full-color Micro-LED chip according to any one of claims 1 to 10, wherein the epitaxial structure comprises the functional layer; the epitaxial structure comprises chip groups in one-to-one correspondence with the unit groups, each of the chip groups comprises a first chip structure corresponding to the first sub-unit, a second chip structure corresponding to the second sub-unit, and a third chip structure corresponding to the third sub-unit, and every two of the first chip structure, the second chip structure, and the third chip structure are spaced apart by an isolation layer.

12. The full-color Micro-LED display apparatus according to claim 11, wherein,
the functional layer further comprises a fourth u-GaN layer, a p-type semiconductor layer, and a p-type ohmic contact layer that are sequentially located on a side of the quantum well layer away from the n-type semiconductor layer; the full-color Micro-LED chip further comprises a first transparent conductive layer, a reflective layer, a metal bonding layer, and a pixel driving circuit element that are sequentially located on a side of the p-type ohmic contact layer away from the p-type semiconductor layer, and the isolation layer extends from the n-type semiconductor layer to the metal bonding layer and penetrates through the n-type semiconductor layer and the metal bonding layer;
and/or, each of a surface of the first chip structure, a surface of the second chip structure, and a surface of the third chip structure is sequentially provided with a passivation layer and a second transparent conductive layer, the second transparent conductive layer penetrates through the passivation layer to be connected to the n-type semiconductor layer, and the epitaxial structure further comprises an n-type ohmic contact electrode connected to the second transparent conductive layer;
and/or, a surface of the n-type semiconductor layer of the first chip structure away from the quantum well layer, a surface of the n-type semiconductor layer of the second chip structure away from the quantum well layer, and a surface of the n-type semiconductor layer of the third chip structure away from the quantum well layer are flush.

13. A preparation method of the full-color Micro-LED chip according to any one of claims 1 to 9, comprising the following steps:
providing a base substrate for forming the substrate layer, wherein the base substrate comprises a layer to be patterned, the layer to be patterned has a first side surface and a second side surface that are opposite, and a direction from the first side surface to the second side surface is parallel to the second direction;
performing patterning processing on the first side surface of the layer to be patterned to form at least one mesa group, wherein each mesa group comprises a first mesa, a second mesa, and a third mesa that are distributed in the first direction, and taking the second side surface of the layer to be patterned as a reference, a height of the first mesa is greater than a height of the second mesa, and the height of the second mesa is greater than a height of the third mesa; wherein the layer to be patterned is formed into a patterned layer after the patterning processing;
sequentially epitaxially growing an n-type semiconductor layer and a quantum well layer on the first side surface of the patterned layer, wherein the quantum well layer comprises a blue quantum well layer, a green quantum well layer, and a red quantum well layer that are sequentially grown on the n-type semiconductor layer, a surface of the blue quantum well layer located on the first mesa away from the n-type semiconductor layer, a surface of the green quantum well layer located on the second mesa away from the n-type semiconductor layer, and a surface of the red quantum well layer located on the third mesa away from the n-type semiconductor layer are flush, to form a flush quantum well surface;
removing, by a first etching process, the green quantum well layer and the red quantum well layer located on the first mesa, and the red quantum well layer located on the second mesa to expose the flush quantum well surface, to form the at least one unit group on the substrate layer, wherein each unit group comprises the first sub-unit located on the first mesa, the second sub-unit located on the second mesa, and the third sub-unit located on the third mesa; and
after exposing the flush quantum well surface, sequentially growing a fourth u-GaN layer, an electron blocking layer, a hole providing layer, and a p-type ohmic contact layer on the flush quantum well surface to obtain the full-color Micro-LED chip.

14. The preparation method of the full-color Micro-LED chip according to claim 13, wherein the patterning processing comprises:
etching the layer to be patterned to form a first groove, wherein the first groove has a side wall and a bottom wall, and a surface of the side wall away from the bottom wall in the second direction is the first mesa; and
etching a partial region of the bottom wall of the first groove to form a second groove, wherein a surface of a region of the bottom wall of the first groove that is not etched is the second mesa, and a bottom surface of the second groove is the third mesa.

15. The preparation method of the full-color Micro-LED chip according to claim 14, wherein,
the etching the layer to be patterned to form a first groove comprises: after spin-coating 1.5 µm to 3 µm of photoresist on the layer to be patterned, exposing a region to be etched through an exposure and development process, and then etching through an inductively coupled plasma etching method to form the first groove;
and/or,
the etching a partial region of the bottom wall of the first groove to form a second groove comprises: after spin-coating 1.5 µm to 3 µm of photoresist on the layer to be patterned in which the first groove is formed, exposing a region to be etched through an exposure and development process, and then etching through an inductively coupled plasma etching method to form the second groove.

16. The preparation method of the full-color Micro-LED chip according to claim 13, wherein the base substrate comprises a substrate, and the preparation method further comprises:
growing a dielectric layer on the substrate, wherein the dielectric layer comprises at least one selected from the group consisting of a silicon oxide compound and a silicon nitride compound;
etching the dielectric layer to form a third groove that exposes the substrate, wherein the dielectric layer that is not etched is annularly arranged on a peripheral side of the third groove;
growing an AlN buffer layer in the third groove; and
growing a first u-GaN layer on the dielectric layer and the AlN buffer layer;
wherein the patterned layer is the substrate or the first u-GaN layer.

17. The preparation method of the full-color Micro-LED chip according to claim 13, wherein,
the n-type semiconductor layer is grown in a hydrogen atmosphere, the quantum well layer is grown in a nitrogen atmosphere, and a growth temperature of the quantum well layer is lower than a growth temperature of the n-type semiconductor layer; and the preparation method further comprises: after the growth of the n-type semiconductor layer is finished, in the nitrogen atmosphere, growing a second u-GaN layer on the n-type semiconductor layer, and then growing a u-In_{x‴}Ga_{1-x‴}N/u-In_{y‴}Ga_{1-y‴}N superlattice layer of 5 to 10 periods on the second u-GaN layer, and then growing the quantum well layer on the u-In_{x‴}Ga_{1-x‴}N/u-In_{y‴}Ga_{1-y‴}N superlattice layer, wherein 0.01≤x‴≤0.1, y‴=0 or 0.005≤y‴≤0.01;
and/or, the red quantum well layer comprises a third potential well layer and a third potential barrier layer; and the preparation method further comprises: after the growth of the quantum well layer is finished, under growth conditions of the third potential barrier layer, growing a third u-GaN layer on the quantum well layer, and then reducing the temperature, the third u-GaN layer is at least partially decomposed during a temperature reduction process, and then performing the first etching process to expose the flush quantum well surface.

18. The preparation method of the full-color Micro-LED chip according to claim 13, wherein the first etching process comprises:
after coating 1.5 µm to 3 µm of photoresist on a surface of the quantum well layer, exposing the red quantum well layer corresponding to the first mesa and the red quantum well layer corresponding to the second mesa through an exposure and development process, and then etching away, through an inductively coupled plasma etching method, the red quantum well layer corresponding to the first mesa and the red quantum well layer corresponding to the second mesa to expose the green quantum well layer corresponding to the first mesa and the green quantum well layer corresponding to the second mesa; and
then coating 1.5 µm to 3 µm of photoresist on the quantum well layer, and then exposing the green quantum well layer corresponding to the first mesa through an exposure and development process, and then etching away the green quantum well layer corresponding to the first mesa through the inductively coupled plasma etching method to expose the blue quantum well layer corresponding to the first mesa, to expose the flush quantum well surface;
and/or, after exposing the flush quantum well surface, growing the fourth u-GaN layer on the flush quantum well surface in a nitrogen atmosphere; and then growing the electron blocking layer on the fourth u-GaN layer in a hydrogen atmosphere, wherein a growth temperature of the electron blocking layer is higher than a growth temperature of the fourth u-GaN layer.

19. A preparation method of a full-color Micro-LED display apparatus, comprising the following steps:
providing the full-color Micro-LED chip according to any one of claims 1 to 10, or preparing a full-color Micro-LED chip according to the preparation method of the full-color Micro-LED chip according to any one of claims 13 to 18; and
bonding the full-color Micro-LED chip to a pixel driving circuit element to obtain the full-color Micro-LED display apparatus.

20. The preparation method of the full-color Micro-LED display apparatus according to claim 19, wherein the bonding the full-color Micro-LED chip to a pixel driving circuit element to obtain the full-color Micro-LED display apparatus comprises:
sequentially growing a first transparent conductive layer, a reflective layer, and a metal bonding layer on the p-type ohmic contact layer of the full-color Micro-LED chip;
bonding the metal bonding layer to the pixel driving circuit element;
removing the substrate layer of the full-color Micro-LED chip;
modifying a surface of the n-type semiconductor layer of the full-color Micro-LED chip away from the quantum well layer to make that a surface of the n-type semiconductor layer of the first sub-unit away from the quantum well layer, a surface of the n-type semiconductor layer of the second sub-unit away from the quantum well layer, and a surface of the n-type semiconductor layer of the third sub-unit away from the quantum well layer are flush;
forming, by a second etching process, gaps between every two adjacent ones of the first sub-unit, the second sub-unit, and the third sub-unit, wherein the gaps extend from the n-type semiconductor layer of the full-color Micro-LED chip to the metal bonding layer and penetrate through the n-type semiconductor layer and the metal bonding layer, to form a first chip structure corresponding to the first sub-unit, a second chip structure corresponding to the second sub-unit, and a third chip structure corresponding to the third sub-unit;
forming isolation layers in the gaps to make that every two of the first chip structure, the second chip structure, and the third chip structure spaced apart by the isolation layers, and sequentially forming a passivation layer and a second transparent conductive layer on each of a surface of the first chip structure, a surface of the second chip structure, and a surface of the third chip structure, and making the second transparent conductive layer penetrate through the passivation layer to be connected to the n-type semiconductor layer; and
then, forming an n-type ohmic contact electrode connected to the second transparent conductive layer to obtain the full-color Micro-LED display apparatus.
